# EUROPEAN PATENT APPLICATION

(11) **EP 4 788 079 A1**
(43) Date of publication of application: **05.08.2026**
(21) Application number: 25217109.5
(22) Date of filing: 19.11.2025
(51) Int. Cl.: H10B 12/00

(54) **SEMICONDUCTOR MEMORY DEVICE**

(30) Priority: 04.02.2025 KR 20250013932
(71) Applicant: Samsung Electronics Co., Ltd., Suwon-si, Gyeonggi-do 16677 (KR)
(72) Inventor: YANG, Guifu, 16677 Suwon-si (KR); KIM, Woochul, 16677 Suwon-si (KR)
(74) Representative: Marks & Clerk LLP

(57) **Abstract**

A semiconductor memory device may include: a substrate; a plurality of semiconductor patterns extending in a first horizontal direction on the substrate, the plurality of semiconductor patterns spaced apart from each other in a vertical direction; a first contact connected to the plurality of semiconductor patterns, the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the second contact includes a metal, and the first contact includes a main layer including doped polysilicon.

## Description

### BACKGROUND

The disclosure relates to a semiconductor memory device, and more particularly, to a three-dimensional (3D) semiconductor memory device.

With the demand for compact and multifunctionalized high-performance electronic products, high-capacity semiconductor memory devices are required. To provide high-capacity semiconductor memory devices, there is demand for an increase in integration density. Therefore, 3D semiconductor memory devices, which increase memory capacity by stacking memory cells on a substrate in the vertical direction, have been suggested.

### SUMMARY

According to some embodiments of the disclosure, a 3D semiconductor memory device having an increased integration density is provided.

According to an aspect of the disclosure, a semiconductor memory device may include: a substrate; a plurality of semiconductor patterns extending in a first horizontal direction on the substrate, the plurality of semiconductor patterns spaced apart from each other in a vertical direction; a first contact connected to the plurality of semiconductor patterns, the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the second contact includes a metal, and the first contact includes a main layer including doped polysilicon.

According to an aspect of the disclosure, a semiconductor memory device may include: a substrate; a plurality of semiconductor patterns extending in a first horizontal direction on the substrate, the plurality of semiconductor patterns spaced apart from each other in a vertical direction; a first contact connected to the plurality of semiconductor patterns, the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the first contact includes a first main layer, the second contact includes a second main layer, and each of the first main layer and the second main layer includes doped polysilicon.

According to an aspect of the disclosure, a semiconductor memory device may include: a substrate; a plurality of semiconductor patterns extending in a first horizontal direction on the substrate, the plurality of semiconductor patterns spaced apart from each other in a vertical direction; a first contact connected to the plurality of semiconductor patterns, the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the first contact includes a metal, and a junction of the first contact is formed by a gas-phase doping process using boron (B).

According to an aspect of the disclosure, a method of manufacturing a semiconductor memory device may include: forming a plurality of semiconductor patterns extending in a first horizontal direction on a substrate, the plurality of semiconductor patterns spaced apart from each other in a vertical direction; forming a first contact, the first contact connected to the plurality of semiconductor patterns, and the first contact extending through the plurality of semiconductor patterns in the vertical direction; forming a bit line on the first contact in the vertical direction, the bit line extending in a second horizontal direction crossing the first horizontal direction; forming a word line, the word line surrounding the plurality of semiconductor patterns, and the word line extending in the first horizontal direction; forming a second contact, the second contact spaced apart from the first contact in the first horizontal direction, and the second contact extending through the plurality of semiconductor patterns in the vertical direction, wherein the second contact includes a metal, and the first contact includes a main layer including doped polysilicon.

According to an aspect of the disclosure, the main layer includes a dopant including boron (B).

According to an aspect of the disclosure, the second contact includes a junction that is formed in a gas-phase doping process using boron (B).

According to an aspect of the disclosure, the first contact further includes a buffer layer surrounding the main layer in the first horizontal direction.

Aspects and effects of embodiments of the disclosure are not limited to those mentioned above, and other aspects and effects of embodiments of the disclosure can be clearly understood by those skilled in the art from the description below.

At least some of the above and other features of the invention are set out in the claims.

### BRIEF DESCRIPTION OF DRAWINGS

Embodiments will be more clearly understood from the following detailed description taken in conjunction with the accompanying drawings, in which:
FIG. 1 is a schematic block diagram of a semiconductor memory device according to embodiments;
FIG. 2 is a circuit diagram of a cell array region in FIG. 1;
FIGS. 3 to 11 are schematic diagrams illustrating parts of a method of manufacturing a semiconductor memory device, according to embodiments;
FIGS. 12A, 12B, and 12C are schematic diagrams illustrating parts of a method of manufacturing a semiconductor memory device, according to embodiments;
FIGS. 13A, 13B, and 13C are schematic diagrams illustrating parts of a method of manufacturing a semiconductor memory device, according to embodiments;
FIGS. 14A, 14B, and 14C are schematic diagrams illustrating parts of a method of manufacturing a semiconductor memory device, according to embodiments;
FIGS. 15A, 15B, and 15C are schematic diagrams illustrating parts of a method of manufacturing a semiconductor memory device, according to embodiments;
FIGS. 16A and 16B are schematic diagrams illustrating parts of a method of manufacturing a semiconductor memory device, according to embodiments;
FIGS. 17A and 17B are schematic diagrams illustrating parts of a method of manufacturing a semiconductor memory device, according to embodiments;
FIGS. 18A and 18B are schematic diagrams illustrating parts of a method of manufacturing a semiconductor memory device, according to embodiments;
FIGS. 19A and 19B are schematic diagrams illustrating parts of a method of manufacturing a semiconductor memory device, according to embodiments;
FIG. 20 is a schematic diagram of a semiconductor memory device according to embodiments; and
FIG. 21 is a schematic diagram of a semiconductor memory device according to embodiments.

### DETAILED DESCRIPTION

Hereinafter, non-limiting example embodiments of the disclosure will be described with reference to the accompanying drawings. In the drawing, like reference characters denote like elements, and redundant descriptions thereof may be omitted.

Non-limiting example embodiments will be illustrated in the drawings and described in detail in the written description. However, the disclosure is not limited to these example embodiments, and it is to be appreciated that all changes, equivalents, and substitutes that do not depart from the scope of the disclosure, as defined in the appended claims, are encompassed in embodiments of the disclosure. In the description of embodiments, certain detailed descriptions of the related art may be omitted when it is deemed that they may unnecessarily obscure aspects of the disclosure.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

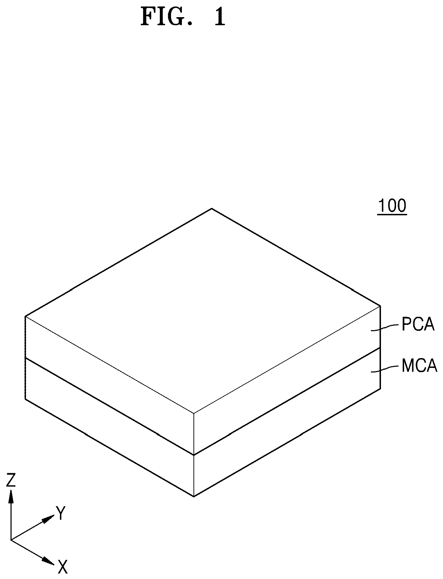

FIG. 1 is a schematic block diagram of a semiconductor memory device according to embodiments.

Referring to FIG. 1, a semiconductor memory device 100 may include a cell array region MCA and a peripheral circuit region PCA at a higher vertical level than a vertical level of the cell array region MCA.

In some embodiments, the cell array region MCA may be a memory cell region of a dynamic random access memory (DRAM) device, and the peripheral circuit region PCA may be a core region or a peripheral circuit region of the DRAM device. For example, the peripheral circuit region PCA may include peripheral circuit transistors that transmit signals and/or power to a memory cell array in the cell array region MCA. In embodiments, the peripheral circuit transistors may form various circuits, such as a command decoder, a control logic, an address buffer, a row decoder, a column decoder, a sense amplifier, and a data input/output circuit.

Although it is illustrated in FIG. 1 that the peripheral circuit region PCA is at a higher vertical level than the vertical level of the cell array region MCA (e.g., the peripheral circuit region PCA is arranged on the top of the cell array region MCA), the semiconductor memory device 100 may be turned upside down such that the cell array region MCA is positioned at a higher vertical level than a vertical level of the peripheral circuit region PCA.

In embodiments, the peripheral circuit region PCA and the cell array region MCA may be respectively formed on separate wafers and then attached to each other by using a bonding pad. In some embodiments, after the peripheral circuit region PCA is formed on a peripheral circuit wafer, the cell array region MCA may be formed on the peripheral circuit region PCA.

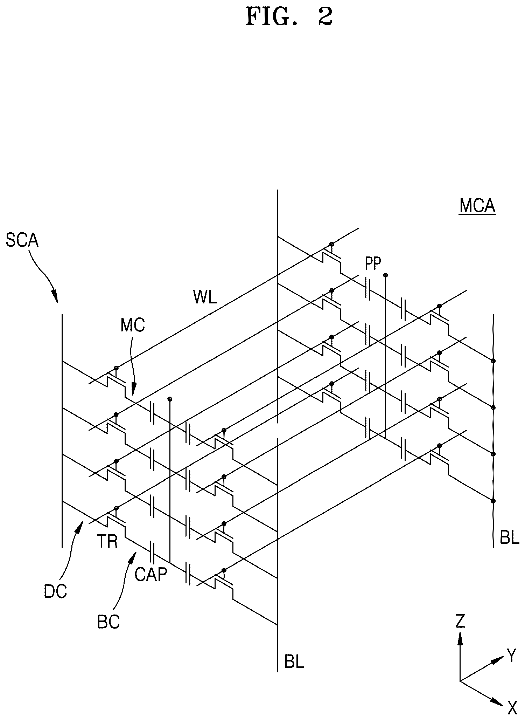

FIG. 2 is a circuit diagram of the cell array region MCA in FIG. 1.

Referring to FIG. 2, the cell array region MCA may include a plurality of sub-cell arrays SCA. The sub-cell arrays SCA may be spaced apart from each other in a second horizontal direction (e.g., a Y direction).

Each of the sub-cell arrays SCA may include a plurality of bit lines BL, a plurality of word lines WL, and a plurality of memory cells MC. Each of the memory cells MC may include a cell transistor TR and a cell capacitor CAP connected to the cell transistor TR. Each of the memory cells MC may have a one transistor-one capacitor (1T1C) structure.

The word lines WL may extend in the second horizontal direction (e.g., the Y direction) and may be spaced apart from each other in a first horizontal direction (e.g., an X direction) and a vertical direction (e.g., a Z direction). The bit lines BL may extend in the vertical direction (e.g., the Z direction) and may be spaced apart from each other in the first horizontal direction (e.g., the X direction) and the second horizontal direction (e.g., the Y direction). One cell transistor TR may be arranged between one word line WL and one bit line BL.

A gate of the cell transistor TR may be connected to the word line WL, and a source of the cell transistor TR may be connected to the bit line BL through a first contact DC. The cell transistor TR may be connected to the cell capacitor CAP through a second contact BC. A drain of the cell transistor TR may be connected to a first electrode of the cell capacitor CAP through the second contact BC, and a second electrode of the cell capacitor CAP may be connected to a plate electrode PP.

In one sub-cell array SCA, a plurality of cell transistors TR may be positioned to overlap each other in the vertical direction (e.g., the Z direction). In one sub-cell array SCA, a plurality of cell capacitors CAP may be positioned to overlap each other in the vertical direction (e.g., the Z direction). One cell transistor TR and one cell capacitor CAP may be arranged in a line at the same vertical level. A plurality of memory cells MC, each including one cell transistor TR and one cell capacitor CAP, may be stacked in the vertical direction (e.g., the Z direction). The storage capacity of the sub-cell array SCA may vary with the number of memory cells MC (e.g., the number of cell capacitors CAP) stacked in the vertical direction (e.g., the Z direction).

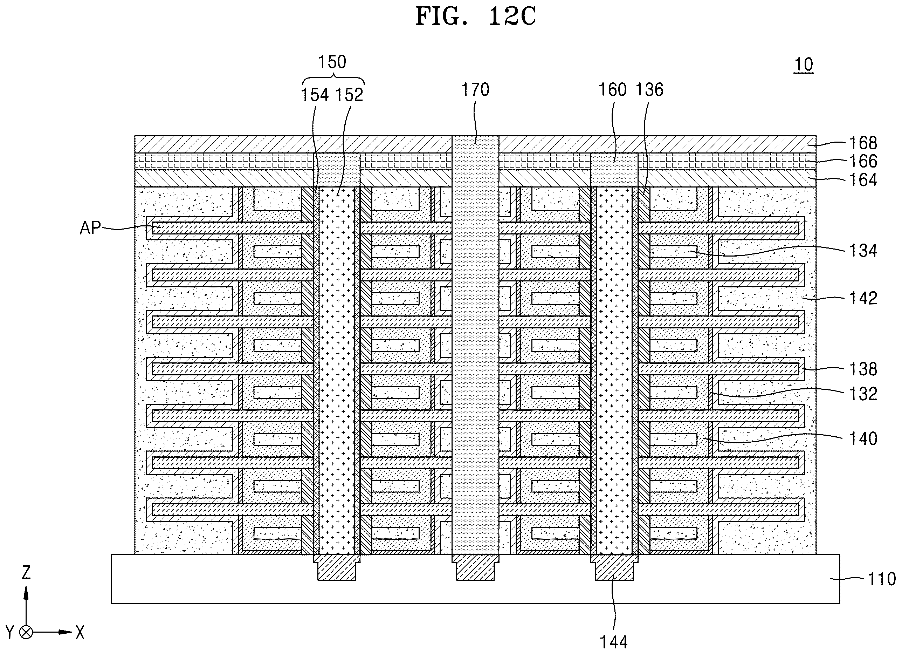

In some embodiments, the first contact DC in the circuit diagram of FIG. 2 may be a direct contact 150 (see FIG. 12C), which is described below. In some embodiments, the second contact BC in the circuit diagram of FIG. 2 may be a buried contact BC (see FIG. 12C), which is described below.

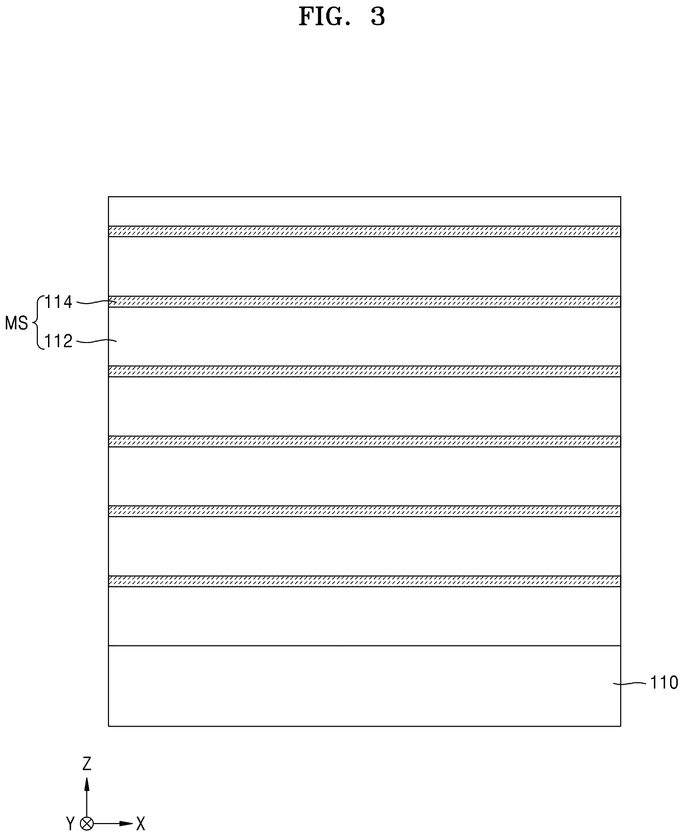

FIGS. 3 to 11 are cross-sectional views illustrating parts of manufacturing processes of the cell array region MCA in FIG. 1.

Referring to FIG. 3, a mold stack MS may be formed by alternately and sequentially forming at least one (e.g., a plurality of) sacrificial mold layer 112 and at least one (e.g., a plurality of) semiconductor layer 114 on a substrate 110.

In embodiments, the substrate 110 may include Si, Ge, or SiGe. In embodiments, the substrate 110 may include a silicon-on-insulator (SOI) substrate or a germanium-on-insulator (GeOI) substrate.

In embodiments, the sacrificial mold layer 112 may include a material having etch selectivity with respect to a material of the semiconductor layer 114. For example, the sacrificial mold layer 112 and the semiconductor layer 114 may each include a monocrystalline layer of a Group IV semiconductor, a Group IV-IV compound semiconductor, or a Group III-V compound semiconductor and may include different materials from each other. For example, the sacrificial mold layer 112 may include SiGe, and the semiconductor layer 114 may include monocrystalline silicon. The sacrificial mold layer 112 and the semiconductor layer 114 may each have a thickness of several tens of nm.

In embodiments, the sacrificial mold layer 112 and the semiconductor layer 114 may be formed by epitaxy. For example, the epitaxy may include vapor-phase epitaxy (VPE), a chemical vapor deposition (CVD) process such as ultra-high vacuum CVD (UHV-CVD), molecular beam epitaxy, or a combination thereof. During the epitaxy, a liquid or gaseous precursor may be used to form the sacrificial mold layer 112 and the semiconductor layer 114.

In embodiments, as shown in FIG. 3, the thickness of the semiconductor layer 114 in the vertical direction (e.g., the Z direction) may be less than the thickness of the sacrificial mold layer 112 in the vertical direction (e.g., the Z direction). In some embodiments, the thickness of the semiconductor layer 114 in the vertical direction (e.g., the Z direction) may be substantially the same as the thickness of a semiconductor pattern AP to be formed in a subsequent process.

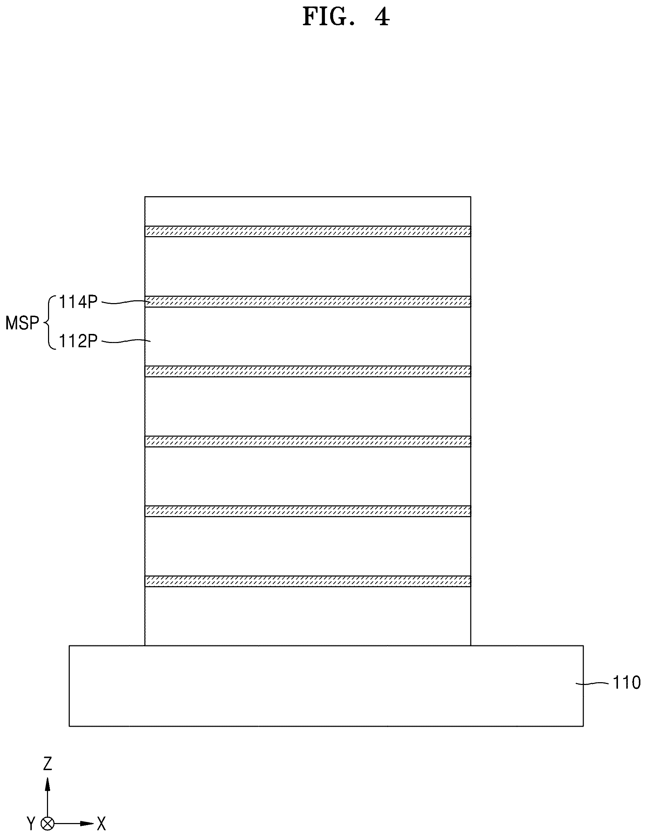

Referring to FIG. 4, a mask pattern may be formed on the mold stack MS, and a portion of the mold stack MS may be removed by using the mask pattern as an etch mask, thereby forming a mold stack pattern MSP including a plurality of semiconductor layer patterns 114P and a plurality of sacrificial mold layer patterns 112P stacked alternately with the semiconductor layer patterns 114P. The semiconductor layer patterns 114P and the sacrificial mold layer patterns 112P may be positioned to overlap each other in the vertical direction (e.g., the Z direction) and may extend in the first horizontal direction (e.g., the X direction).

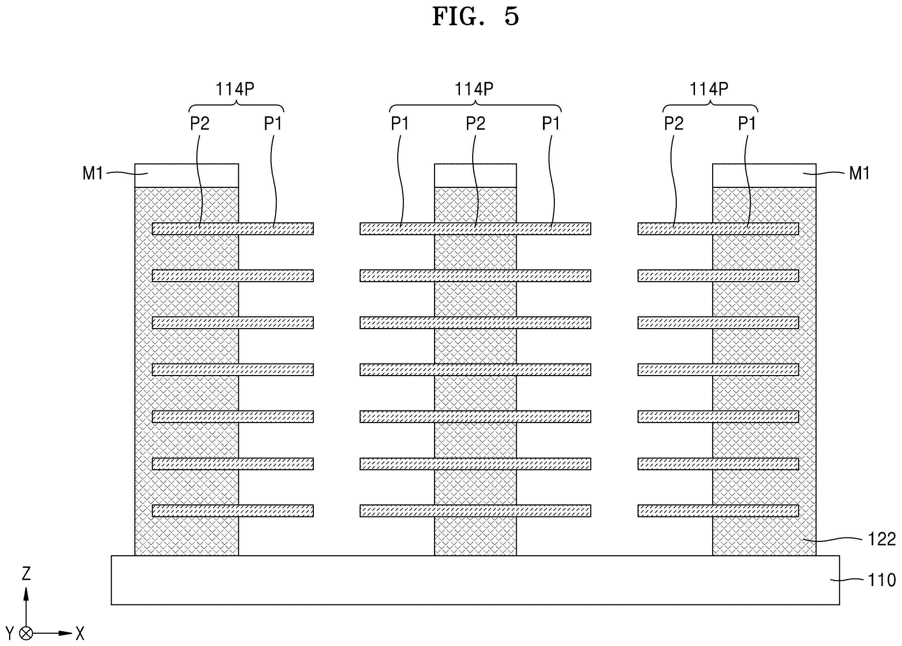

Referring to FIG. 5, the sacrificial mold layer patterns 112P may be removed, and a first gapfill insulating layer 122 may be formed in spaces, from which the sacrificial mold layer patterns 112P are removed, by using an insulating material.

In embodiments, the process of removing the sacrificial mold layer patterns 112P may include a wet etching process or a pull-back process. For example, the process of removing the sacrificial mold layer patterns 112P may include an etching process using etch selectivity between the sacrificial mold layer patterns 112P and the semiconductor layer patterns 114P. For example, in the wet etching process or the pull-back process, the etch rate of the semiconductor layer patterns 114P may be relatively low, and the etch rate of the sacrificial mold layer patterns 112P may be relatively high.

Thereafter, a first mask pattern M1 may be formed on the first gapfill insulating layer 122. Each of the semiconductor layer patterns 114P may include at least one first portion P1 and a second portion P2. The first mask pattern M1 may be arranged to vertically overlap the second portion P2 of each of the semiconductor layer patterns 114P.

Thereafter, a portion of the first gapfill insulating layer 122, which is not covered by the first mask pattern M1, may be removed so that the first portion P1 of each of the semiconductor layer patterns 114P may be exposed. The second portion P2 of each of the semiconductor layer patterns 114P may be covered by the first gapfill insulating layer 122 and thus may not be exposed. In embodiments, the process of removing a portion of the sacrificial mold layer 112 may include a lateral recess process or a pull-back process.

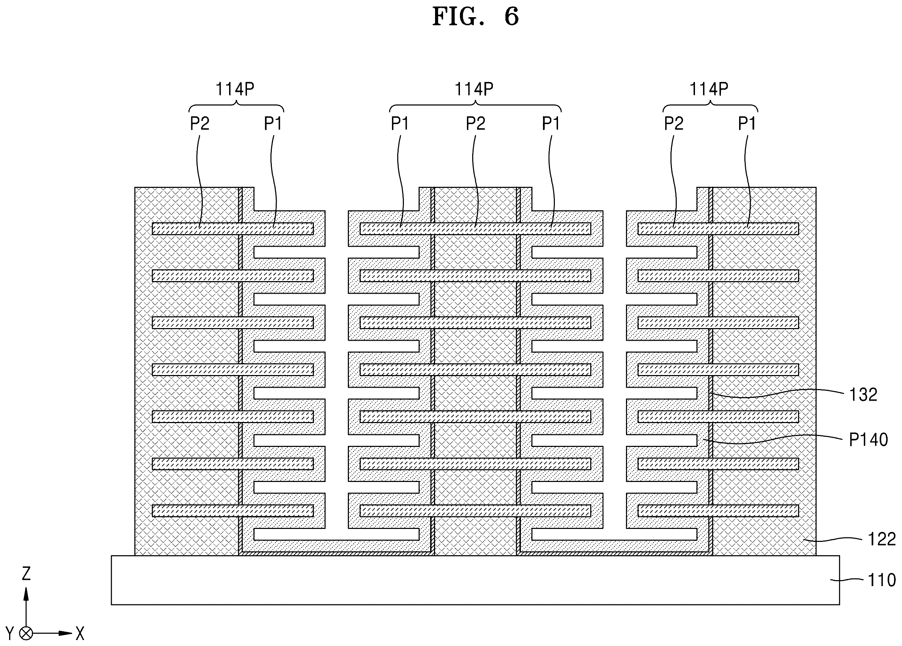

Referring to FIG. 6, a first insulating liner 132 and a preliminary word line P140 may be formed on the top and bottom surfaces and a sidewall of the first portion P1 of each of the semiconductor layer patterns 114P. In some embodiments, the first insulating liner 132 and the preliminary word line P140 may also be formed on the top surface of the substrate 110. In embodiments, the first insulating liner 132 may be formed using at least one selected from among silicon oxide, silicon nitride, and silicon oxynitride. In embodiments, the preliminary word line P140 may include at least one from among Ti, TiN, TiAlC, TiAlN, TiSiN, MoSiN, WN, WSiN, Ta, TaSiN, TaN, LaN, and a combination thereof.

In some embodiments, a gate insulating layer may be arranged between the preliminary word line P140 and the semiconductor layer patterns 114P. The gate insulating layer may include at least one from among a ferroelectric material and a high-k dielectric material having a higher dielectric constant than a dielectric constant of silicon oxide. In some embodiments, the gate insulating layer may include at least one from among hafnium oxide (HfO), hafnium silicon oxide (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicon oxide (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PbZrTiO), strontium bismuth tantalate (SrTaBiO), bismuth iron oxide (BiFeO), strontium titanium oxide (SrTiO), yttrium oxide (YO), aluminum oxide (AlO), and lead scandium tantalum oxide (PbScTaO).

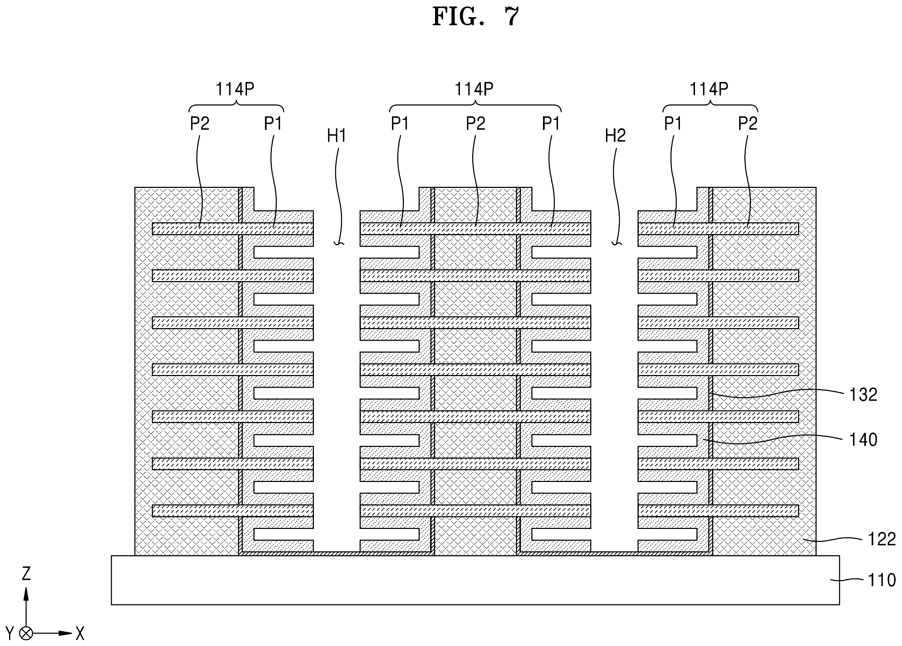

Referring to FIG. 7, a word line 140 may be formed by removing a portion of the preliminary word line P140. In some embodiments, the portion of the preliminary word line P140 may be removed by an etching process. As the portion of the preliminary word line P140 is removed, an end of the first portion P1 of each of the semiconductor layer patterns 114P may be exposed. In some embodiments, as the portion of the preliminary word line P140 is removed, a portion of the first insulating liner 132 covering the top surface of the substrate 110 may be exposed. As shown in FIG. 7, spaces on the top surface of the substrate 110, between first portions P1 of adjacent ones of the semiconductor layer patterns 114P in the first horizontal direction (e.g., the X direction), may be referred to as a first space H1 and a second space H2.

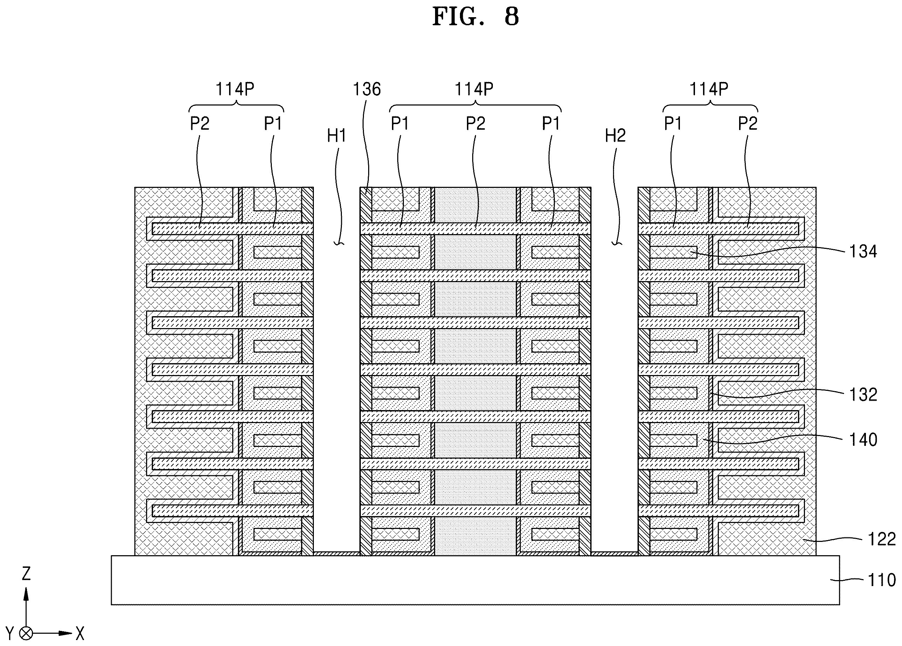

Referring to FIG. 8, a second gapfill insulating layer 134 may be formed to fill a space surrounded by the word line 140, which has a C-shaped cross-section between two semiconductor layer patterns 114P adjacent to each other in the vertical direction (e.g., the Z direction), and a second insulating liner 136 may be formed to surround an end portion of the first portion P1 of each of the semiconductor layer patterns 114P and fill a side portion of the first space H1 and a side portion of the second space H2. In the process of forming the second gapfill insulating layer 134 and the second insulating liner 136, an end portion of the word line 140 may be removed. In some embodiments, the process of removing the end portion of the word line 140 may include a lateral recess process or a pull-back process.

In some embodiments, as the word line 140 surrounds portions of the top and bottom surfaces of a semiconductor layer pattern 114P, the semiconductor memory device 100 may be referred to as a gate-all-around device.

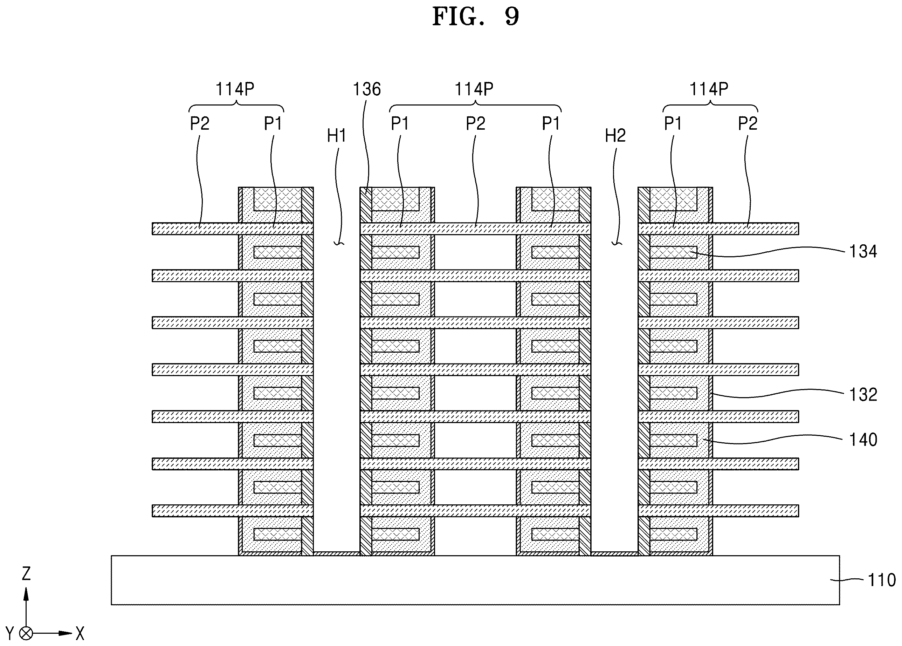

Referring to FIG. 9, a mask pattern may be formed on the first gapfill insulating layer 122, and the second portion P2 of each of the semiconductor layer patterns 114P may be exposed by removing a portion of the first gapfill insulating layer 122 by using the mask pattern as an etch mask. In embodiments, the process of removing the portion of the first gapfill insulating layer 122 may include a lateral recess process or a pull-back process.

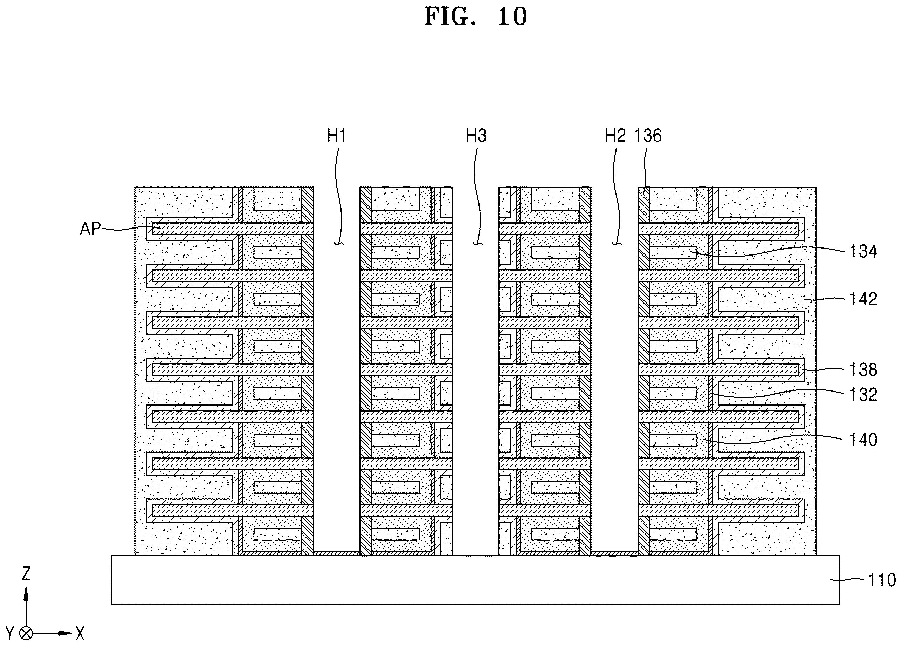

Referring to FIG. 10, a third insulating liner 138 and a third gapfill insulating layer 142 may be sequentially formed on the second portion P2 of each of the semiconductor layer patterns 114P. The third insulating liner 138 may be conformally formed on the sidewall of the first insulating liner 132 and the exposed surface of the second portion P2 of each of the semiconductor layer patterns 114P, and the third gapfill insulating layer 142 may be formed on the third insulating liner 138 to surround the second portion P2 of each of the semiconductor layer patterns 114P.

Subsequently, a third space H3 may be formed by etching second portions P2 of semiconductor layer patterns 114P arranged on the central portion of the substrate 110. As portions of the second portions P2 of the semiconductor layer patterns 114P arranged on the central portion of the substrate 110 are removed, a portion of the top surface of the substrate 110 may be exposed.

Portions of the semiconductor layer patterns 114P remaining after the portions of the second portions P2 of the semiconductor layer patterns 114P arranged on the central portion of the substrate 110, among the plurality of semiconductor layer patterns 114P, are removed may be referred to as semiconductor patterns AP.

In embodiments, the semiconductor patterns AP may include an undoped semiconductor material or a doped semiconductor material. In embodiments, the semiconductor patterns AP may include polysilicon. In embodiments, the semiconductor patterns AP may include amorphous metal oxide, polycrystalline metal oxide, or a combination of amorphous metal oxide and polycrystalline metal oxide. For example, the semiconductor patterns AP may include at least one from among In-Ga oxide (IGO), In-Zn oxide (IZO), and In-Ga-Zn oxide (IGZO). In some embodiments, the semiconductor patterns AP may include a two-dimensional (2D) material semiconductor. For example, the 2D material semiconductor may include MoS₂, WSe₂, graphene, carbon nanotube, or a combination thereof.

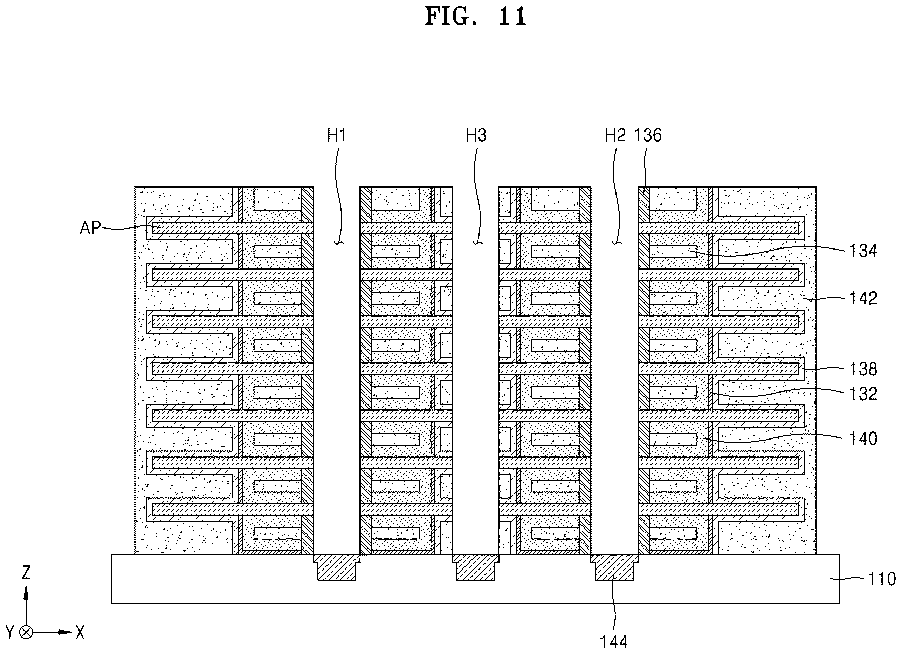

Referring to FIG. 11, an insulating structure 144 may be formed at the bottom of each of the first space H1, the second space H2, and the third space H3. The insulating structure 144 may be formed by removing a portion of the substrate 110 and filling a space, from which the portion of the substrate 110 has been removed, with an insulating material. In embodiments, the top surface of the insulating structure 144 may be coplanar with the top surface of the substrate 110. In the process of forming the insulating structure 144, portions of the first insulating liner 132 on the substrate 110 may be removed.

In embodiments, the insulating structure 144 may be formed using at least one from among silicon oxide, silicon nitride, and silicon oxynitride.

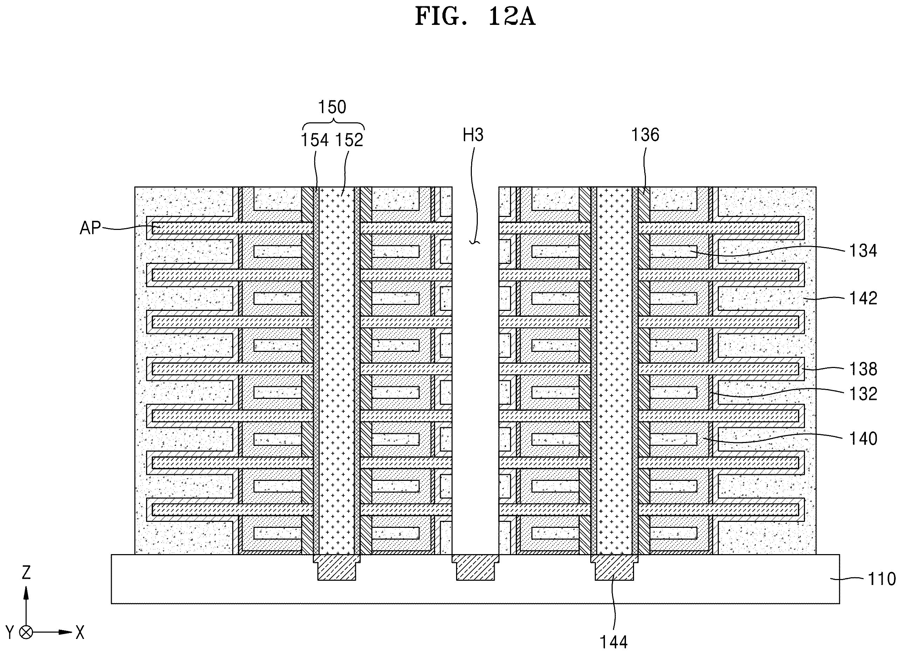

FIGS. 12A to 12C are schematic diagrams illustrating parts of a method of manufacturing a semiconductor memory device 10, according to embodiments
Referring to FIG. 12A, a direct contact 150 may be formed by forming a buffer layer 154 conformally covering each of the sidewall of the first space H1 (see FIG. 11) and the sidewall of the second space H2 (see FIG. 11) in the resultant structure of FIG. 11 and forming a main layer 152 filling a space remaining (e.g., a remainder of the first space H1 and the second space H2) after forming the buffer layer 154.

In embodiments, the buffer layer 154 may include polysilicon that does not include a dopant, and the main layer 152 may include polysilicon including a dopant. The dopant included in the main layer 152 may be, for example, boron (B). In some embodiments, the thickness of the buffer layer 154 may not be greater (e.g. may be less than) than the thickness of the main layer 152, but embodiments are not limited thereto.

In some embodiments, the buffer layer 154 may help control a dopant doping concentration in the direct contact 150 (see FIGS. 12A and 12C).

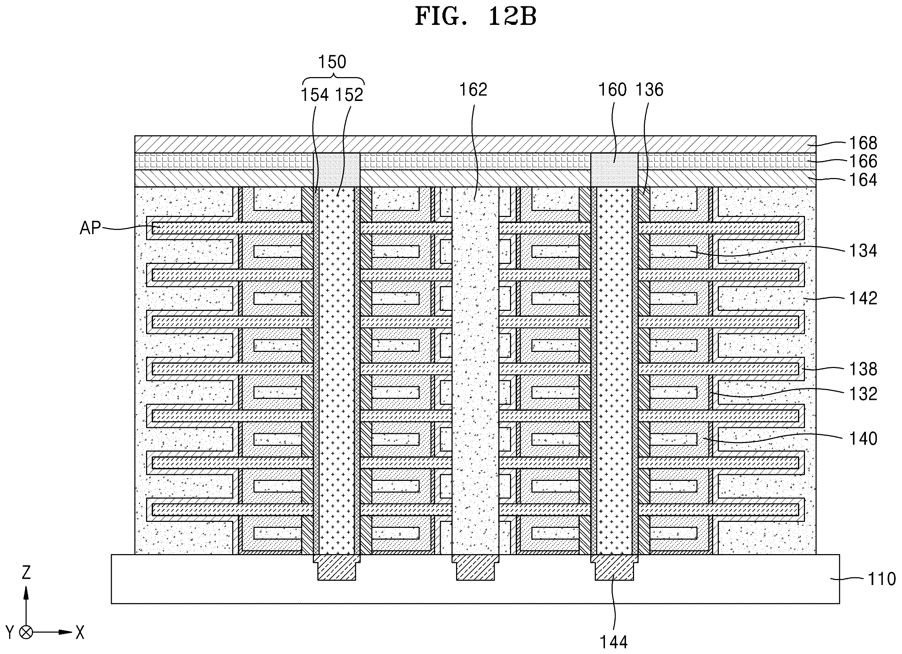

Referring to FIG. 12B, the third space H3 may be filled with a fourth gapfill insulating layer 162. A first isolation insulating layer 164, a second isolation insulating layer 166, a bit line 160, and a third isolation insulating layer 168 may be sequentially formed to cover the top surfaces of the second gapfill insulating layer 134, the third gapfill insulating layer 142, the fourth gapfill insulating layer 162, the word line 140, the first insulating liner 132, the second insulating liner 136, the third insulating liner 138, and the direct contact 150. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound.

Referring to FIG. 12C, the fourth gapfill insulating layer 162 filling the third space H3 (see FIG. 12A) may be removed. In embodiments, the fourth gapfill insulating layer 162 may be removed by an etching process. As the fourth gapfill insulating layer 162 is removed, the top surface of the insulating structure 144 below the fourth gapfill insulating layer 162 may be exposed. In the process of removing the fourth gapfill insulating layer 162, portions of the first, second, and third isolation insulating layers 164, 166, and 168 may also be removed. Subsequently, a buried contact 170 may be formed in a space from which the fourth gapfill insulating layer 162 and the first, second, and third isolation insulating layers 164, 166, and 168 have been removed.

According to some embodiments, gas-phase doping may be performed as a pre-process before the buried contact 170 is formed. In embodiments, the gas-phase doping may be performed using B, for example, B₂H₆. Before the buried contact 170 is formed, a B₂H₆ gas may be injected in a high-temperature environment so that B may diffuse, as a dopant, from the surfaces of the semiconductor patterns AP. The buried contact 170 may be formed by forming a buried contact junction by using the gas-phase doping process and then filling the third space H3 with a metal material.

Through the processes described above, the semiconductor memory device 10 may be manufactured.

The semiconductor memory device 10 may increase the integration density and simplify processes by using the semiconductor patterns AP, which are vertically stacked to form an N-channel metal-oxide semiconductor (NMOS) transistor on the substrate 110, as a channel layer of a P-channel MOS (PMOS) transistor. Accordingly, a high-density PMOS transistor may be formed by using the surplus space of the substrate 110.

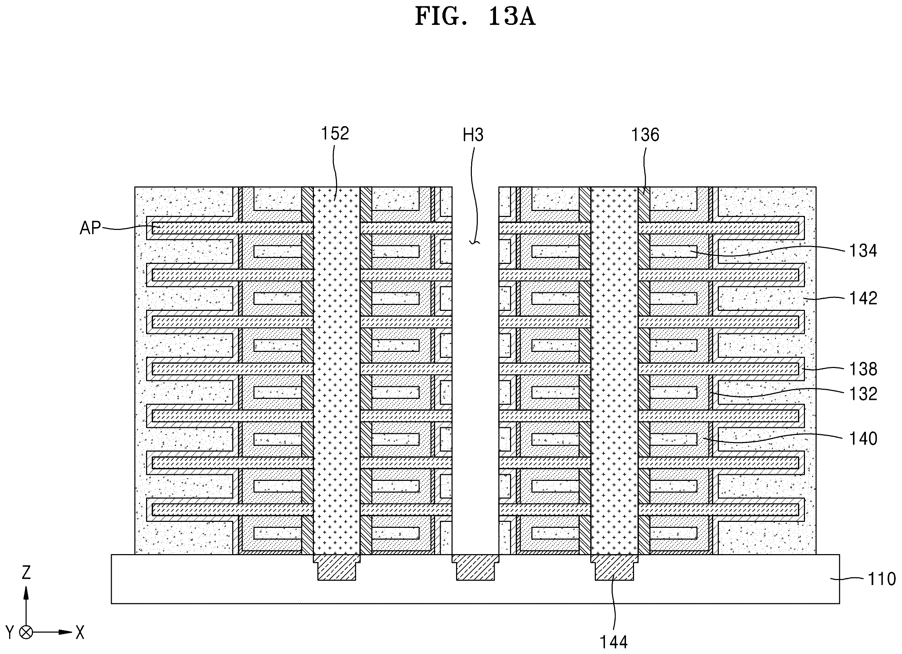

FIGS. 13A to 13C are schematic diagrams illustrating parts of a method of manufacturing a semiconductor memory device 10a, according to embodiments. The semiconductor memory device 10a described with reference to FIGS. 13A to 13C and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10a and the semiconductor memory device 10 of FIGS. 3 to 12C are mainly described.

Referring to FIG. 13A, in the resultant structure of FIG. 11, the main layer 152 may be formed to completely fill each of the first space H1 and the second space H2. In an embodiment, the main layer 152 may include polysilicon including a dopant. The dopant included in the main layer 152 may be, for example, B. The main layer 152 of the present embodiment may be the direct contact 150.

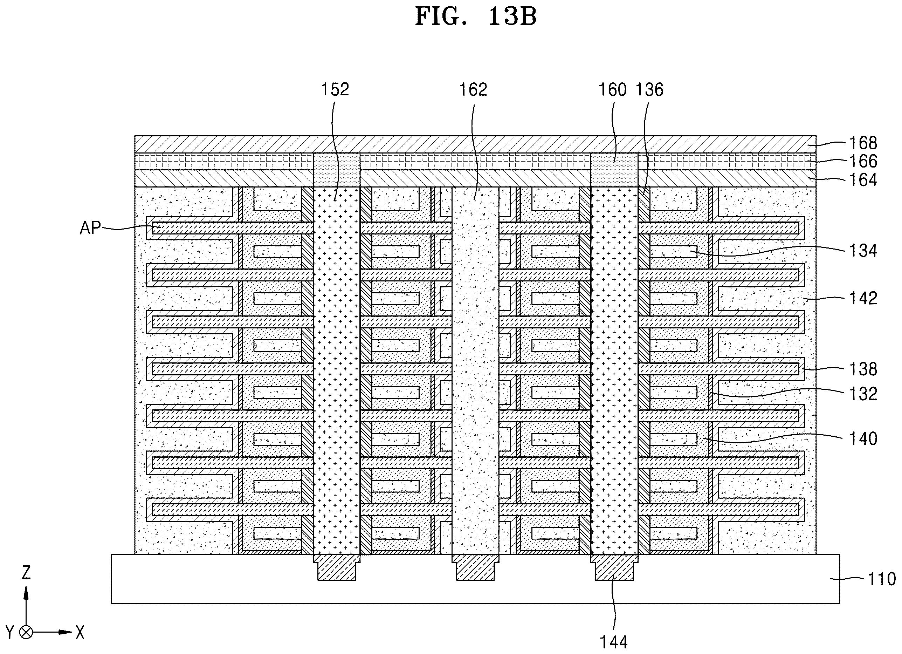

Referring to FIG. 13B, the third space H3 may be filled with the fourth gapfill insulating layer 162. The first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the fourth gapfill insulating layer 162, the word line 140, the first insulating liner 132, the second insulating liner 136, the third insulating liner 138, and the direct contact 150. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound.

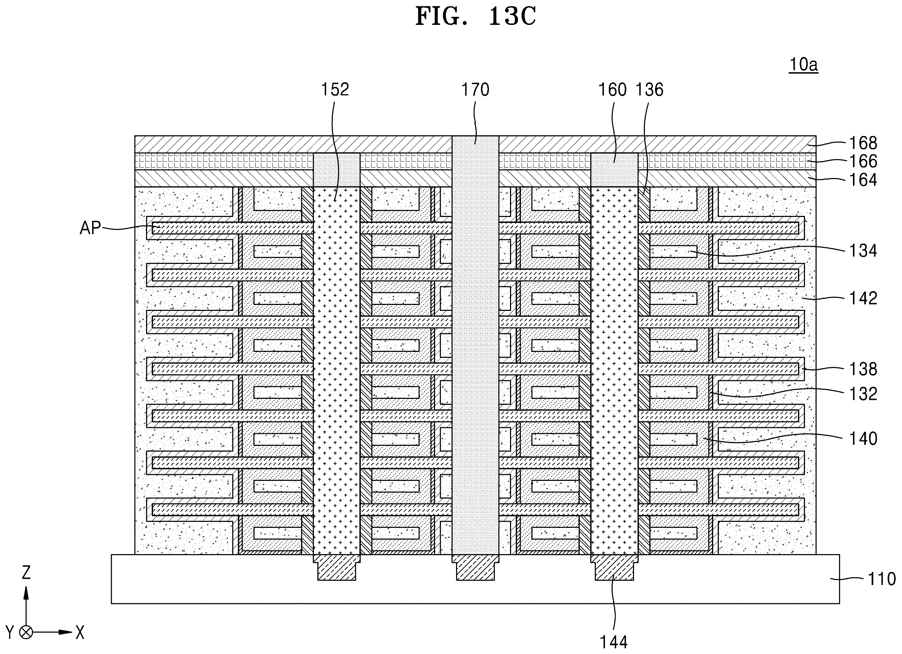

Referring to FIG. 13C, the fourth gapfill insulating layer 162 filling the third space H3 (see FIG. 12A) may be removed. In embodiments, the fourth gapfill insulating layer 162 may be removed by an etching process. As the fourth gapfill insulating layer 162 is removed, the top surface of the insulating structure 144 below the fourth gapfill insulating layer 162 may be exposed. In the process of removing the fourth gapfill insulating layer 162, portions of the first, second, and third isolation insulating layers 164, 166, and 168 may also be removed. Subsequently, the buried contact 170 may be formed in a space from which the fourth gapfill insulating layer 162 and the first, second, and third isolation insulating layers 164, 166, and 168 have been removed.

According to some embodiments, gas-phase doping may be performed as a pre-process before the buried contact 170 is formed. In embodiments, the gas-phase doping may be performed using B, for example, B₂H₆. Before the buried contact 170 is formed, a B₂H₆ gas may be injected in a high-temperature environment so that B may diffuse, as a dopant, from the surfaces of the semiconductor patterns AP. The buried contact 170 may be formed by forming a buried contact junction by using the gas-phase doping process and then filling the third space H3 with a metal material.

Through the processes described above, the semiconductor memory device 10a may be manufactured.

The semiconductor memory device 10a may be substantially the same as the semiconductor memory device 10, except that the buffer layer 154 (see FIG. 12C) at each of the opposite sides of the main layer 152 is omitted. Accordingly, the semiconductor memory device 10a may also increase integration density and simplify processes.

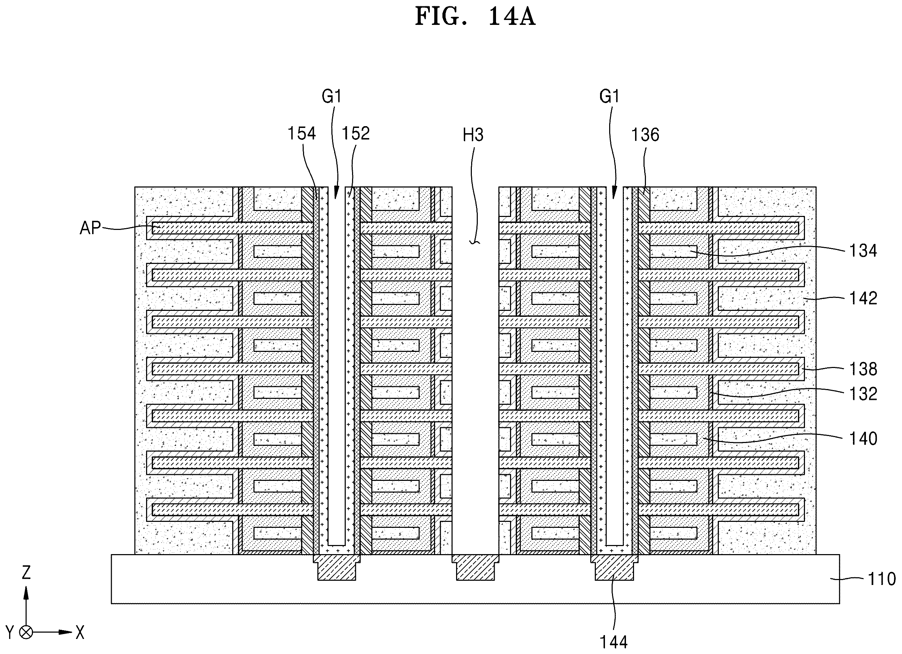

FIGS. 14A to 14C are schematic diagrams illustrating parts of a method of manufacturing a semiconductor memory device 10b, according to embodiments. The semiconductor memory device 10b described with reference to FIGS. 14A to 14C and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10b and the semiconductor memory device 10 of FIGS. 3 to 12C are mainly described.

Referring to FIG. 14A, the buffer layer 154 may be formed to conformally cover each of the sidewall of the first space H1 (see FIG. 11) and the sidewall of the second space H2 (see FIG. 11) in the resultant structure of FIG. 11, and the main layer 152 may be formed to fill a portion of the space remaining after the buffer layer 154 is formed.

In embodiments, the main layer 152 may not fill the whole of the space remaining after the buffer layer 154 is formed. In other words, the main layer 152 may not fully fill each of the first space H1 and the second space H2 (in FIG. 11) so that a first gap G1 may remain as a void.

In embodiments, the buffer layer 154 may include polysilicon that does not include a dopant, and the main layer 152 may include polysilicon including a dopant. The dopant included in the main layer 152 may be, for example, B.

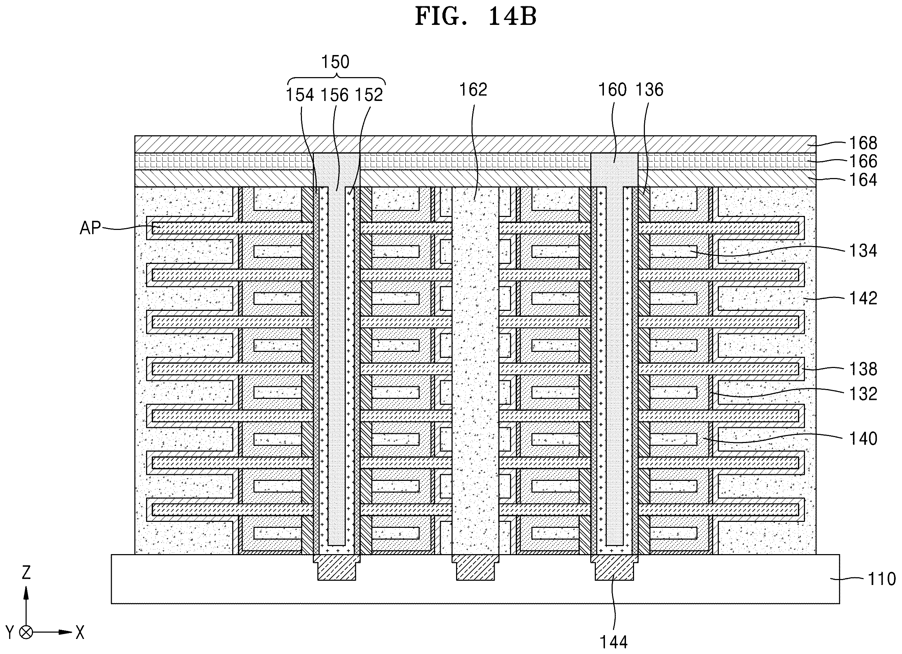

Referring to FIG. 14B, the third space H3 may be filled with the fourth gapfill insulating layer 162. The first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the fourth gapfill insulating layer 162, the word line 140, the first insulating liner 132, the second insulating liner 136, the third insulating liner 138, the main layer 152, and the buffer layer 154. In addition, a metal layer 156 filling the first gap G1 and located below the bit line 160 may be formed. Specifically, after the first isolation insulating layer 164 and the second isolation insulating layer 166 are formed, a portion of each of the first isolation insulating layer 164 and the second isolation insulating layer 166 may be removed. Subsequently, the metal layer 156 filling the first gap G1 (see FIG. 14A) may be formed, and the bit line 160 extending in the second horizontal direction (e.g., the Y direction) may be formed in a space, from which the portions of the first isolation insulating layer 164 and the second isolation insulating layer 166 have been removed. Because the main layer 152, the buffer layer 154, and the metal layer 156 may collectively be referred to as the direct contact 150, the bit line 160 may be formed on the direct contact 150. Thereafter, the third isolation insulating layer 168 may be formed to surround the top surface of the bit line 160 and the top surface of the second isolation insulating layer 166.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound.

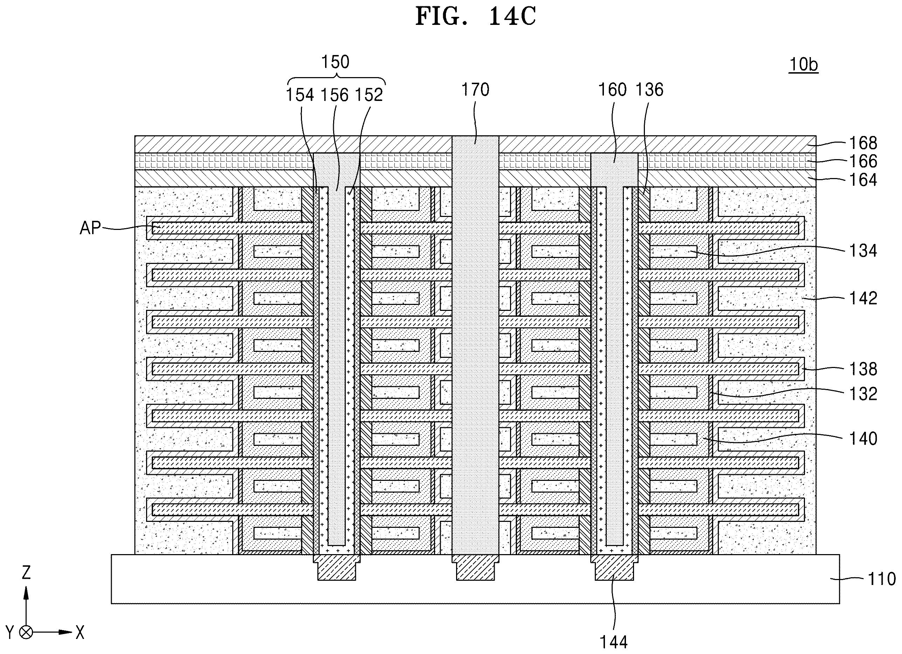

Referring to FIG. 14C, the fourth gapfill insulating layer 162 filling the third space H3 (see FIG. 14A) may be removed. In embodiments, the fourth gapfill insulating layer 162 may be removed by an etching process. As the fourth gapfill insulating layer 162 is removed, the top surface of the insulating structure 144 below the fourth gapfill insulating layer 162 may be exposed. In the process of removing the fourth gapfill insulating layer 162, portions of the first, second, and third isolation insulating layers 164, 166, and 168 may also be removed. Subsequently, the buried contact 170 may be formed in a space from which the fourth gapfill insulating layer 162 and the first, second, and third isolation insulating layers 164, 166, and 168 have been removed.

According to some embodiments, gas-phase doping may be performed as a pre-process before the buried contact 170 is formed. In embodiments, the gas-phase doping may be performed using B, for example, B₂H₆. Before the buried contact 170 is formed, a B₂H₆ gas may be injected in a high-temperature environment so that B may diffuse, as a dopant, from the surfaces of the semiconductor patterns AP. The buried contact 170 may be formed by forming a buried contact junction by using the gas-phase doping process and then filling the third space H3 with a metal material.

Through the processes described above, the semiconductor memory device 10b may be manufactured.

The semiconductor memory device 10b described with reference to FIGS. 14A to 14C may be substantially the same as the semiconductor memory device 10 described with reference to FIGS. 12A to 12C, except that the direct contact 150 is completely formed by filling a space, which remains by the main layer 152 that does not fill the entire space surrounded by the buffer layer 154, with the metal layer 156. Accordingly, the semiconductor memory device 10b may also increase integration density and simplify processes.

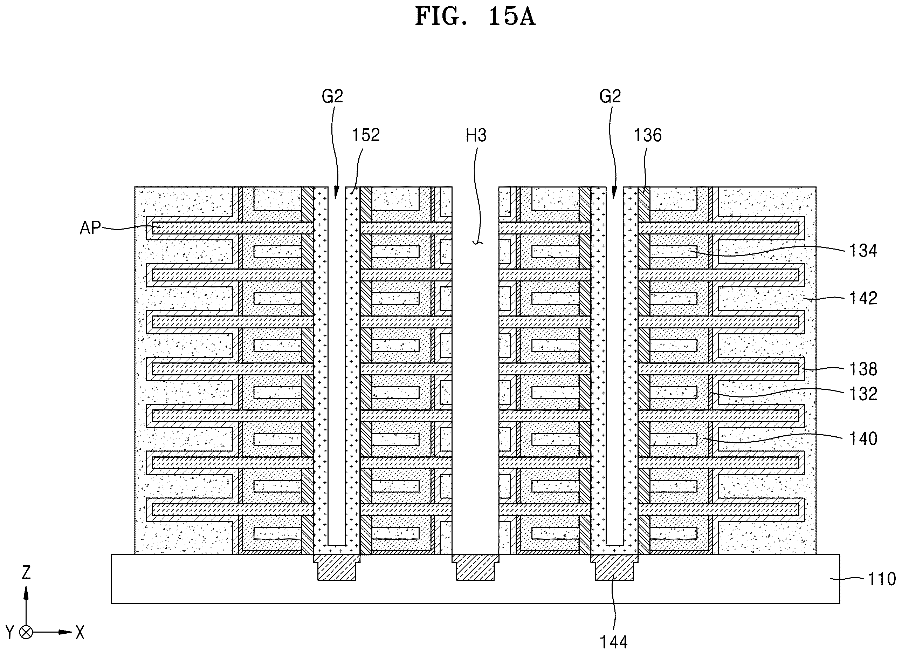

FIGS. 15A to 15C are schematic diagrams illustrating parts of a method of manufacturing a semiconductor memory device 10c, according to embodiments. The semiconductor memory device 10c described with reference to FIGS. 15A to 15C and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10c and the semiconductor memory device 10 of FIGS. 3 to 12C are mainly described.

Referring to FIG. 15A, the main layer 152 may be formed to fill each of the first space H1 (see FIG. 11) and the second space H2 (see FIG. 11) in the resultant structure of FIG. 11. In embodiments, the main layer 152 may include polysilicon including a dopant. The dopant included in the main layer 152 may be, for example, B. The main layer 152 may not completely fill each of the first space H1 and the second space H2 so that a second gap G2 may remain as a void.

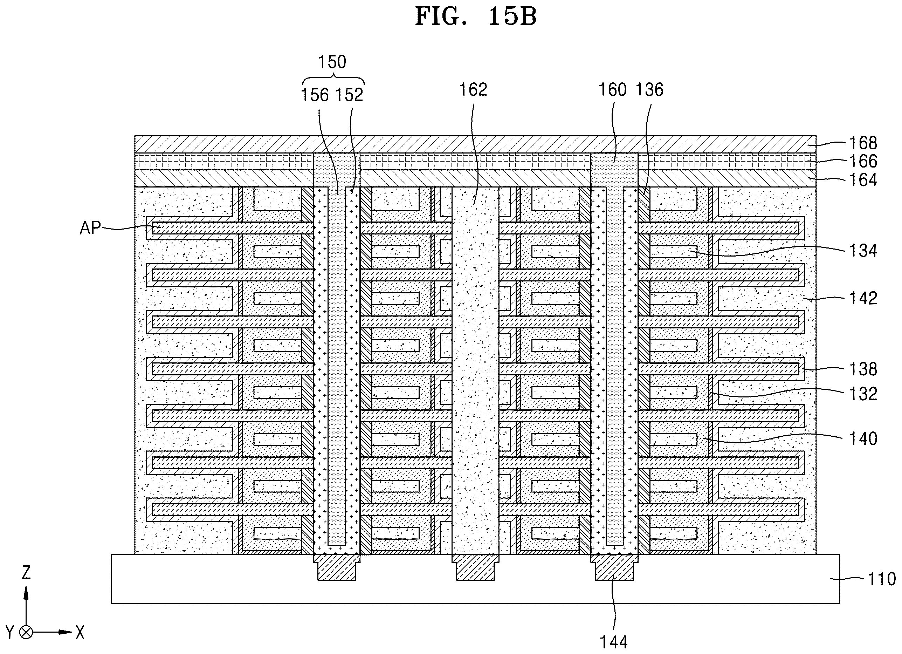

Referring to FIG. 15B, the third space H3 may be filled with the fourth gapfill insulating layer 162. The first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the fourth gapfill insulating layer 162, the word line 140, the first insulating liner 132, the second insulating liner 136, the third insulating liner 138, and the main layer 152. In addition, the metal layer 156 filling the first gap G1 and located below the bit line 160 may be formed. Specifically, after the first isolation insulating layer 164 and the second isolation insulating layer 166 are formed, a portion of each of the first isolation insulating layer 164 and the second isolation insulating layer 166 may be removed. Subsequently, the metal layer 156 filling the second gap G2 (see FIG. 15A) may be formed, and the bit line 160 extending in the second horizontal direction (e.g., the Y direction) may be formed in a space, from which the portions of the first isolation insulating layer 164 and the second isolation insulating layer 166 have been removed. Because the main layer 152 and the metal layer 156 may collectively be referred to as the direct contact 150, the bit line 160 may be formed on the direct contact 150. Thereafter, the third isolation insulating layer 168 may be formed to surround the top surface of the bit line 160 and the top surface of the second isolation insulating layer 166.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound.

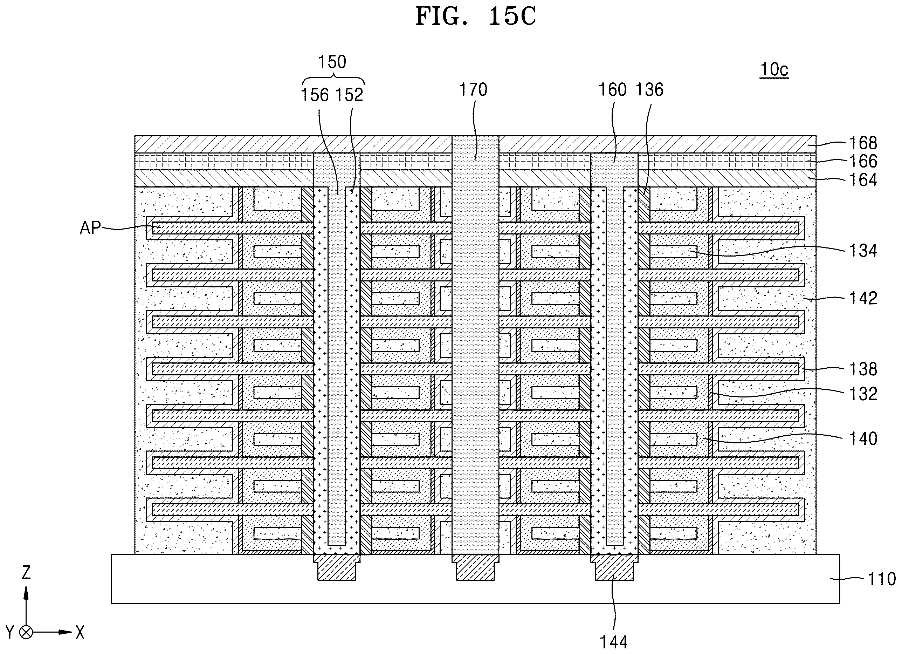

Referring to FIG. 15C, the fourth gapfill insulating layer 162 filling the third space H3 (see FIG. 15A) may be removed. In embodiments, the fourth gapfill insulating layer 162 may be removed by an etching process. As the fourth gapfill insulating layer 162 is removed, the top surface of the insulating structure 144 below the fourth gapfill insulating layer 162 may be exposed. In the process of removing the fourth gapfill insulating layer 162, portions of the first, second, and third isolation insulating layers 164, 166, and 168 may also be removed. Subsequently, the buried contact 170 may be formed in a space from which the fourth gapfill insulating layer 162 and the first, second, and third isolation insulating layers 164, 166, and 168 have been removed.

According to some embodiments, gas-phase doping may be performed as a pre-process before the buried contact 170 is formed. In embodiments, the gas-phase doping may be performed using B, for example, B₂H₆. Before the buried contact 170 is formed, a B₂H₆ gas may be injected in a high-temperature environment so that B may diffuse, as a dopant, from the surfaces of the semiconductor patterns AP. The buried contact 170 may be formed by forming a buried contact junction by using the gas-phase doping process and then filling the third space H3 with a metal material.

Through the processes described above, the semiconductor memory device 10c may be manufactured.

The semiconductor memory device 10c described with reference to FIGS. 15A to 15C may be substantially the same as the semiconductor memory device 10 described with reference to FIGS. 12A to 12C, except that the main layer 152 is directly formed without the buffer layer 154 and that the direct contact 150 is completely formed by forming the metal layer 156 in a space remaining after the main layer 152 does not completely fill each of the first space H1 and the second space H2. Accordingly, the semiconductor memory device 10c may also increase integration density and simplify processes.

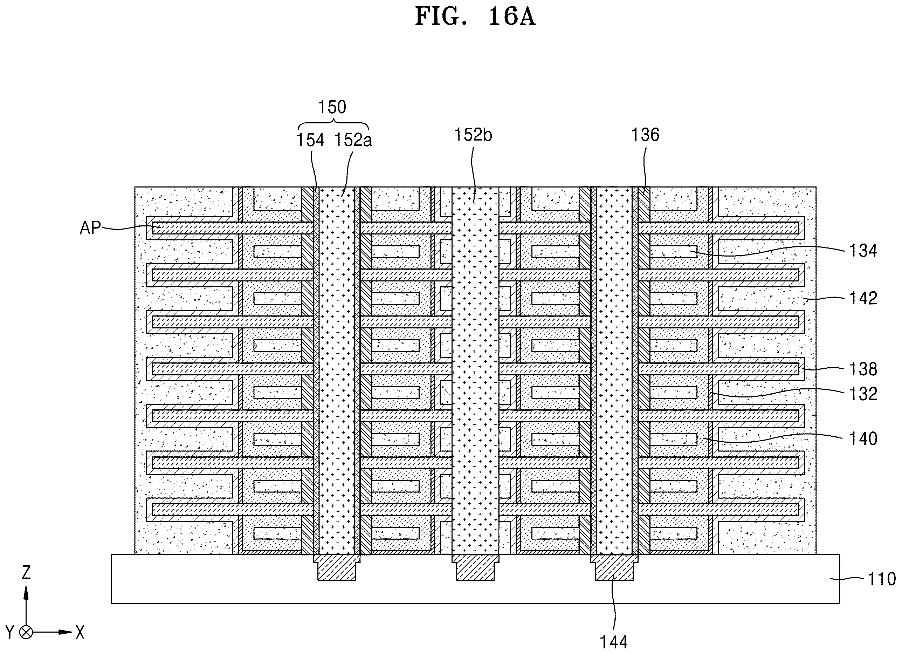

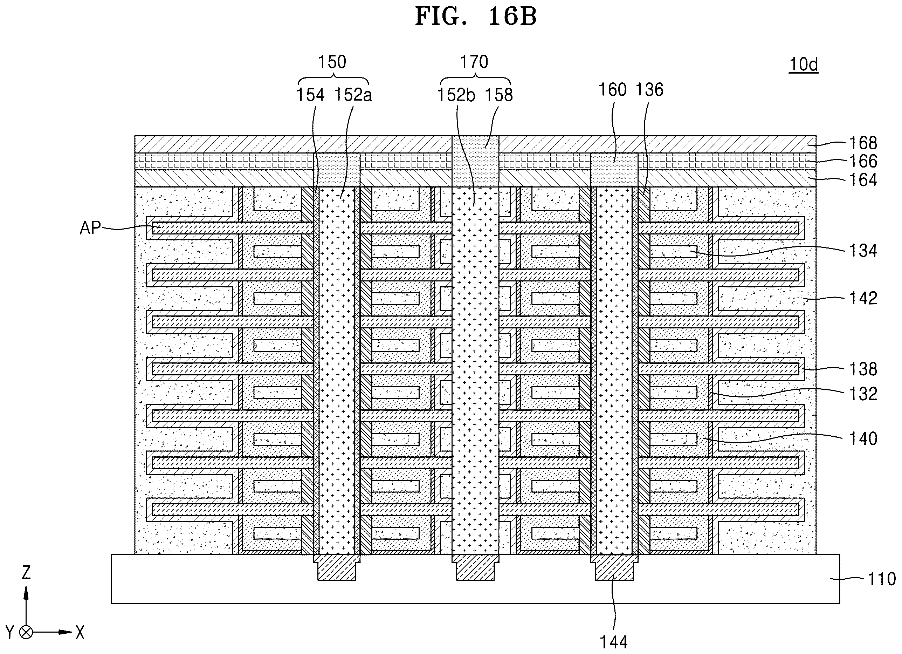

FIGS. 16A and 16B are schematic diagrams illustrating parts of a method of manufacturing a semiconductor memory device 10d, according to embodiments. The semiconductor memory device 10d described with reference to FIGS. 16A and 16B and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10d and the semiconductor memory device 10 of FIGS. 3 to 12C are mainly described.

Referring to FIG. 16A, the direct contact 150 may be formed by forming the buffer layer 154 conformally covering each of the sidewall of the first space H1 (see FIG. 11) and the sidewall of the second space H2 (see FIG. 11) in the resultant structure of FIG. 11 and forming a first main layer 152a filling a space remaining after forming the buffer layer 154. The third space H3 (see FIG. 11) may be filled with a second main layer 152b.

In some embodiments, the process of forming the buffer layer 154 and the first main layer 152a may be performed before the process of forming the second main layer 152b. In some embodiments, the process of forming the buffer layer 154 and the first main layer 152a may be performed after the process of forming the second main layer 152b. In some embodiments, the process of forming the first main layer 152a may be simultaneously performed with the process of forming the second main layer 152b.

In embodiments, the buffer layer 154 may include polysilicon that does not include a dopant, and the first main layer 152a and the second main layer 152b may each include polysilicon including a dopant. The dopant included in each of the first main layer 152a and the second main layer 152b may be, for example, B. In some embodiments, the first main layer 152a and the second main layer 152b may include substantially the same material as each other. In some embodiments, the thickness of the buffer layer 154 may not be greater than the thickness of the first main layer 152a, but embodiments are not limited thereto.

Referring to FIG. 16B, the first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the second main layer 152b, and the direct contact 150. A conductive pattern 158 may be formed on the second main layer 152b by removing a portion of each of the first, second, and third isolation insulating layers 164, 166, and 168. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166. Thereafter, the portion of each of the first, second, and third isolation insulating layers 164, 166, and 168 may be removed so that the top surface of the second main layer 152b is exposed, and a space from which the portions of the first, second, and third isolation insulating layers 164, 166, and 168 have been removed may be filled with the conductive pattern 158. In the present embodiment, the second main layer 152b and the conductive pattern 158 may be collectively referred to as the buried contact 170.

In the present embodiment, the direct contact 150 and the buried contact 170 may respectively include doped polysilicon layers (i.e., the first main layer 152a and the second main layer 152b), and accordingly, the gas-phase doping process, which is performed before the buried contact 170 is formed in the embodiments described above, may be omitted.

In embodiments, the first isolation insulating layer 164 and the third isolation insulating layer 168 may include a nitride-based material, and the second isolation insulating layer 166 may include oxide. In embodiments, the conductive pattern 158 may include metal.

In embodiments, the bit line 160 may include a doped semiconductor material, conductive metal nitride, metal, or a metal-semiconductor compound.

Through the processes described above, the semiconductor memory device 10d may be manufactured.

The semiconductor memory device 10d described with reference to FIGS. 16A and 16B may be substantially the same as the semiconductor memory device 10 described with reference to FIGS. 12A to 12C, except that a portion of the buried contact 170 includes doped polysilicon. Accordingly, the semiconductor memory device 10d may also increase integration density and simplify processes. Because the buried contact 170 of the semiconductor memory device 10d of FIG. 16B includes the second main layer 152b, the second main layer 152b and the first main layer 152a included in the direct contact 150 may be simultaneously or sequentially formed according to a user's settings.

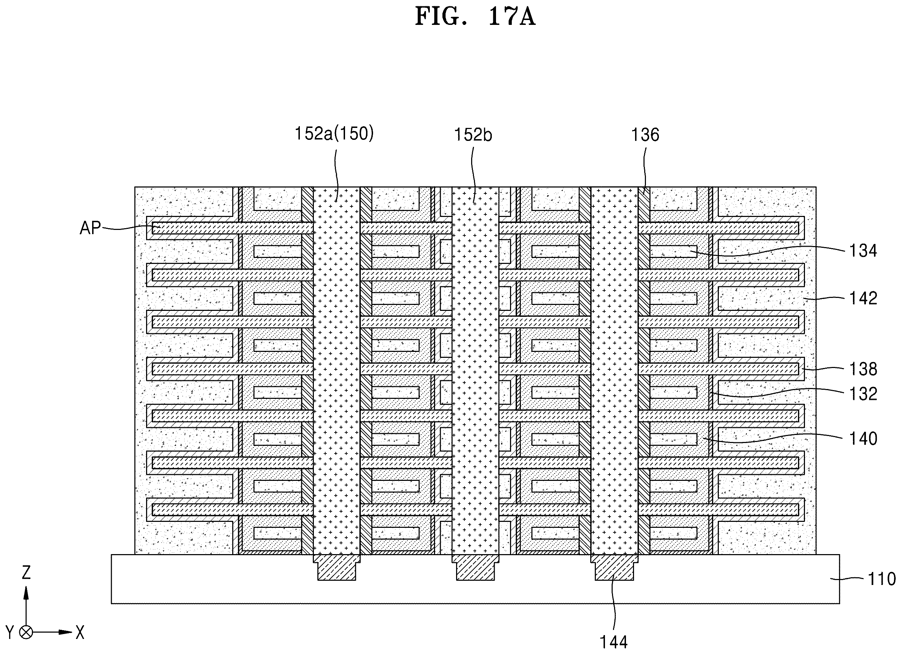

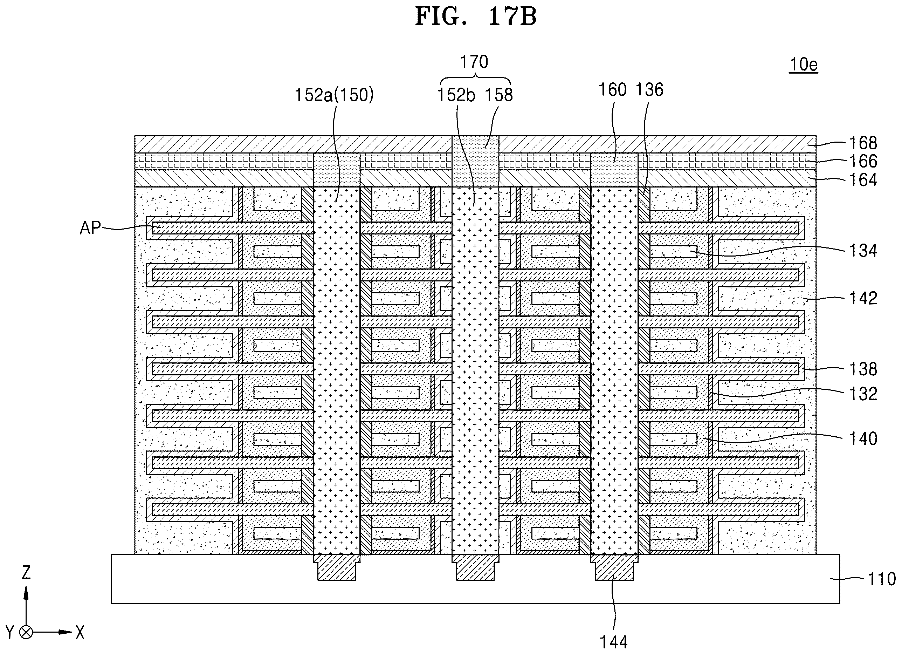

FIGS. 17A and 17B are schematic diagrams illustrating parts of a method of manufacturing a semiconductor memory device 10e, according to embodiments. The semiconductor memory device 10e described with reference to FIGS. 17A and 17B and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10e and the semiconductor memory device 10 of FIGS. 3 to 12C are mainly described.

Referring to FIG. 17A, in the resultant structure of FIG. 11, the first main layer 152a may be formed to completely fill each of the first space H1 and the second space H2 (see FIG. 11), and the second main layer 152b may be formed to fill the third space H3 (see FIG. 11). In the present embodiment, the first main layer 152a may be referred to as the direct contact 150.

In some embodiments, the process of forming the first main layer 152a may be performed before the process of forming the second main layer 152b. In some embodiments, the process of forming the first main layer 152a may be performed after the process of forming the second main layer 152b. In some embodiments, the process of forming the first main layer 152a may be simultaneously performed with the process of forming the second main layer 152b.

In embodiments, the first main layer 152a and the second main layer 152b may each include polysilicon including a dopant. The dopant included in each of the first main layer 152a and the second main layer 152b may be, for example, B. In some embodiments, the first main layer 152a and the second main layer 152b may include substantially the same material as each other.

Referring to FIG. 17B, the first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the second main layer 152b, and the direct contact 150. The conductive pattern 158 may be formed on the second main layer 152b by removing a portion of each of the first, second, and third isolation insulating layers 164, 166, and 168. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166. Thereafter, the portion of each of the first, second, and third isolation insulating layers 164, 166, and 168 may be removed so that the top surface of the second main layer 152b is exposed, and a space from which the portions of the first, second, and third isolation insulating layers 164, 166, and 168 have been removed may be filled with the conductive pattern 158. In the present embodiment, the second main layer 152b and the conductive pattern 158 may be collectively referred to as the buried contact 170.

In the present embodiment, the direct contact 150 and the buried contact 170 may respectively include doped polysilicon layers (i.e., the first main layer 152a and the second main layer 152b), and accordingly, the gas-phase doping process, which is performed before the buried contact 170 is formed in the embodiments described above, may be omitted.

In embodiments, the first isolation insulating layer 164 and the third isolation insulating layer 168 may include a nitride-based material, and the second isolation insulating layer 166 may include oxide. In embodiments, the conductive pattern 158 may include metal.

In embodiments, the bit line 160 may include a doped semiconductor material, conductive metal nitride, metal, or a metal-semiconductor compound.

Through the processes described above, the semiconductor memory device 10e may be manufactured.

The semiconductor memory device 10e described with reference to FIGS. 17A and 17B may be substantially the same as the semiconductor memory device 10 described with reference to FIGS. 12A to 12C, except that the direct contact 150 does not include the buffer layer 154 (see FIG. 12C) and that a portion of the buried contact 170 includes doped polysilicon. Accordingly, the semiconductor memory device 10e may also increase integration density and simplify processes. Because the buried contact 170 of the semiconductor memory device 10e of FIG. 17B includes the second main layer 152b, the second main layer 152b and the first main layer 152a included in the direct contact 150 may be simultaneously or sequentially formed according to a user's settings.

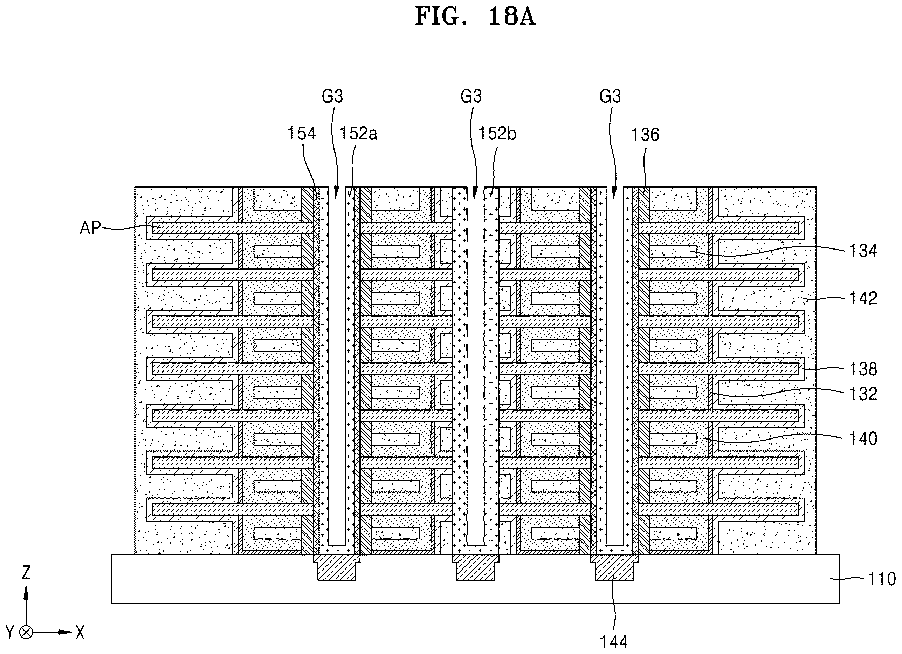

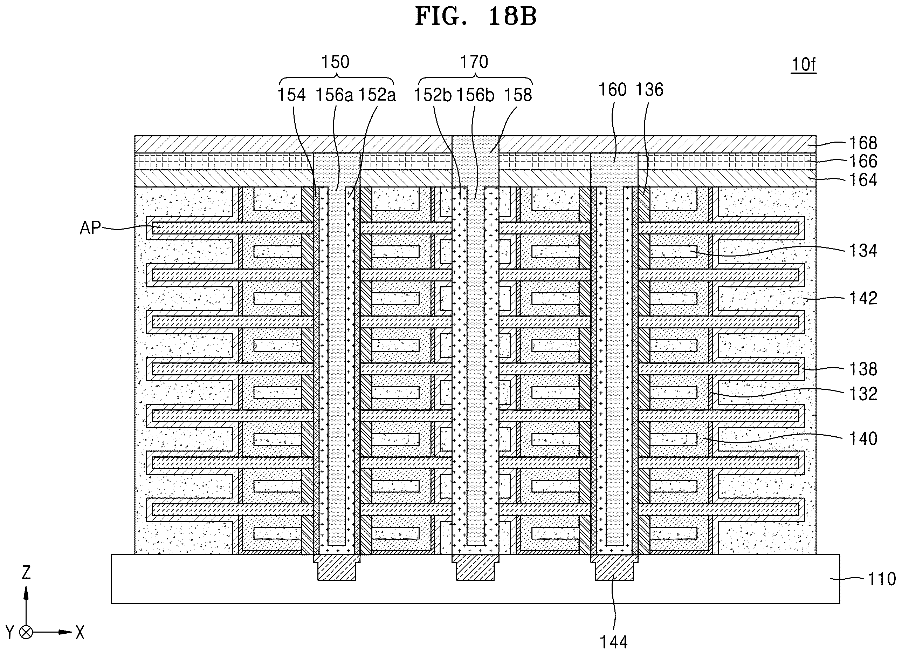

FIGS. 18A and 18B are schematic diagrams illustrating parts of a method of manufacturing a semiconductor memory device 10f, according to embodiments. The semiconductor memory device 10f described with reference to FIGS. 18A and 18B and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10f and the semiconductor memory device 10 of FIGS. 3 to 12C are mainly described.

Referring to FIG. 18A, the buffer layer 154 may be formed to conformally cover the sidewall of the first space H1 (see FIG. 11) and the sidewall of the second space H2 (see FIG. 11) in the resultant structure of FIG. 11, and the first main layer 152a may be formed to fill a portion of a space remaining after the buffer layer 154 is formed. The second main layer 152b may be formed to fill a portion of the third space H3 (see FIG. 11). The first main layer 152a may not fill the whole of the remaining space in each of the first space H1 and the second space H2 and may thus include a third gap G3. Similarly, the second main layer 152b may not fill the whole of the third space H3 and may thus include a third gap G3.

In some embodiments, the process of forming the buffer layer 154 and the first main layer 152a may be performed before the process of forming the second main layer 152b. In some embodiments, the process of forming the buffer layer 154 and the first main layer 152a may be performed after the process of forming the second main layer 152b. In some embodiments, the process of forming the first main layer 152a may be simultaneously performed with the process of forming the second main layer 152b.

In embodiments, the buffer layer 154 may include polysilicon that does not include a dopant, and the first main layer 152a and the second main layer 152b may each include polysilicon including a dopant. The dopant included in each of the first main layer 152a and the second main layer 152b may be, for example, B. In some embodiments, the first main layer 152a and the second main layer 152b may include substantially the same material as each other.

Referring to FIG. 18B, the first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the first main layer 152a, the second main layer 152b, and the buffer layer 154. In addition, a first metal layer 156a filling the third gap G3 (in FIG. 18A) of the first main layer 152a and located below the bit line 160 may be formed, and a second metal layer 156b filling the third gap G3 (in FIG. 18A) of the second main layer 152b may be formed. Specifically, after the second metal layer 156b filling the third gap G3 of the second main layer 152b is formed, the first isolation insulating layer 164 and the second isolation insulating layer 166 may be formed, and a portion of each of the first isolation insulating layer 164 and the second isolation insulating layer 166 may be removed. Subsequently, the first metal layer 156a filling the third gap G3 (in FIG. 18A) may be formed, and the bit line 160 extending in the second horizontal direction (e.g., the Y direction) may be formed in a space, from which the portions of the first isolation insulating layer 164 and the second isolation insulating layer 166 have been removed. In the present embodiment, the first main layer 152a, the buffer layer 154, and the first metal layer 156a may be collectively referred to as the direct contact 150, and thus, the bit line 160 may be formed on the direct contact 150. Thereafter, the third isolation insulating layer 168 may be formed to surround the top surface of the bit line 160 and the top surface of the second isolation insulating layer 166. Thereafter, a portion of each of the first, second, and third isolation insulating layers 164, 166, and 168 may be removed so that the top surfaces of the second main layer 152b and the second metal layer 156b are exposed, and the conductive pattern 158 may be formed to fill a space from which the portions of the first, second, and third isolation insulating layers 164, 166, and 168 have been removed. In the present embodiment, the second main layer 152b, the second metal layer 156b, and the metal pattern 158 may be collectively referred to as the buried contact 170.

In the present embodiment, the direct contact 150 and the buried contact 170 may respectively include doped polysilicon layers (i.e., the first main layer 152a and the second main layer 152b), and accordingly, the gas-phase doping process, which is performed before the buried contact 170 is formed in the embodiments described above, may be omitted.

In embodiments, the first isolation insulating layer 164 and the third isolation insulating layer 168 may include a nitride-based material, and the second isolation insulating layer 166 may include oxide. In embodiments, the first metal layer 156a and the second metal layer 156b may include substantially the same material as each other, and the conductive pattern 158 may include metal.

In embodiments, the bit line 160 may include a doped semiconductor material, conductive metal nitride, metal, or a metal-semiconductor compound.

Through the processes described above, the semiconductor memory device 10f may be manufactured.

The semiconductor memory device 10f described with reference to FIGS. 18A and 18B may be substantially the same as the semiconductor memory device 10 described with reference to FIGS. 12A to 12C, except that the direct contact 150 is completely formed by forming the first metal layer 156a in the remaining space since the first main layer 152a does not completely fill a space surrounded by the buffer layer 154, and that the buried contact 170 includes the second main layer 152b including polysilicon. Accordingly, the semiconductor memory device 10f may also increase integration density and simplify processes.

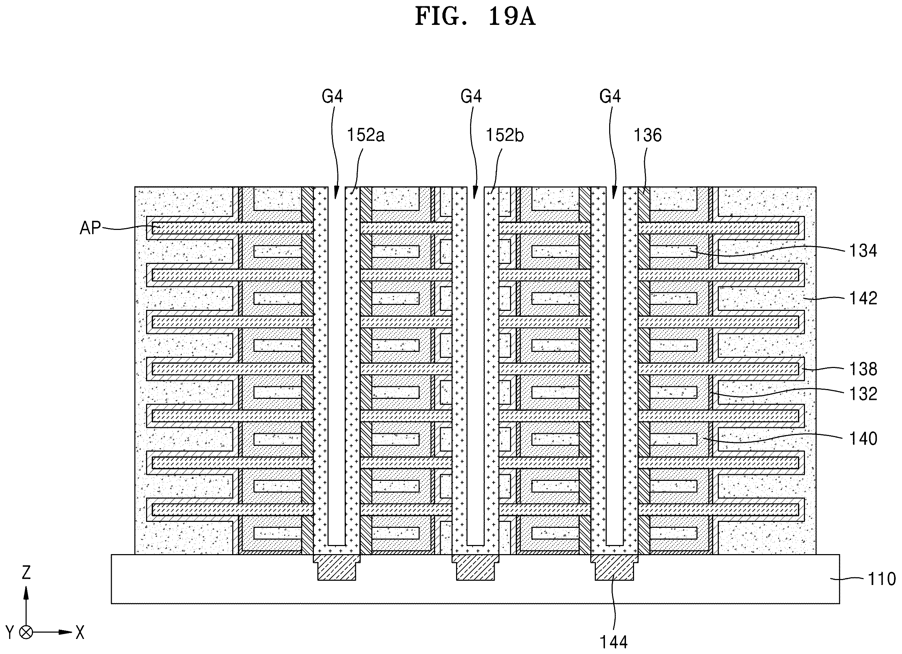

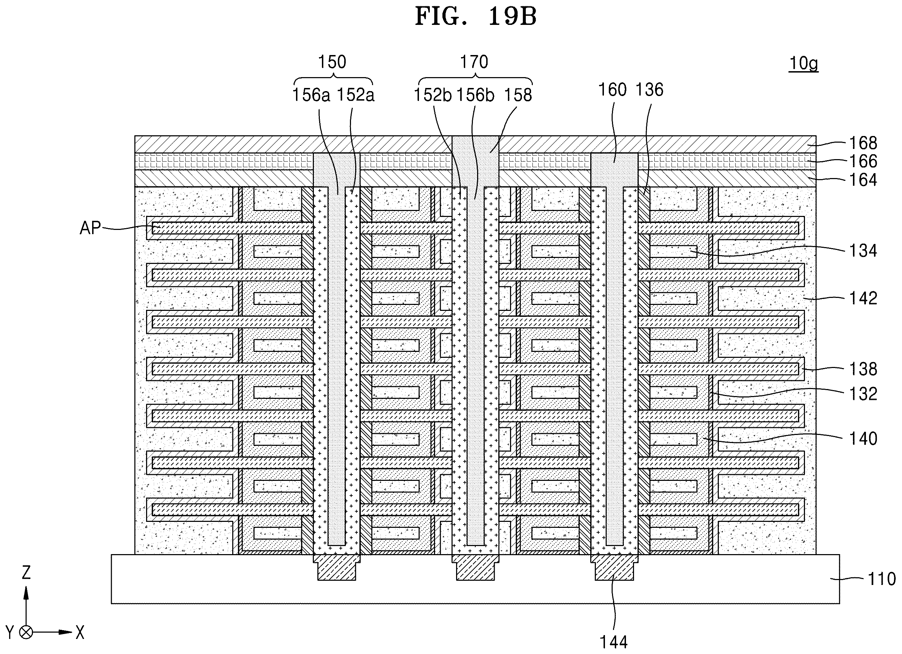

FIGS. 19A and 19B are schematic diagrams illustrating parts of a method of manufacturing a semiconductor memory device 10g, according to embodiments. The semiconductor memory device 10g described with reference to FIGS. 19A and 19B and the semiconductor memory device 10 described with reference to FIGS. 3 to 12C are not mutually exclusive, and like elements are denoted by like reference characters. Redundant descriptions of like elements may be omitted below, and the differences between the semiconductor memory device 10g and the semiconductor memory device 10 of FIGS. 3 to 12C are mainly described.

Referring to FIG. 19A, in the resultant structure of FIG. 11, the first main layer 152a may be formed in each of the first space H1 (see FIG. 11) and the second space H2 (see FIG. 11), and the second main layer 152b may be formed in the third space H3 (see FIG. 11). In embodiments, the first main layer 152a and the second main layer 152b may each include polysilicon including a dopant. In some embodiments, the first main layer 152a and the second main layer 152b may include substantially the same material as each other. The dopant included in each of the first main layer 152a and the second main layer 152b may be, for example, B. Each of the first main layer 152a and the second main layer 152b may not completely fill one of the first, second, and third spaces H1, H2, and H3 so that a fourth gap G4 may remain as a void.

In embodiments, the first main layer 152a and the second main layer 152b may be simultaneously formed, the first main layer 152a may be formed first, or the second main layer 152b may be formed first.

Referring to FIG. 19B, the first metal layer 156a may be formed to completely fill the fourth gap G4 defined by the first main layer 152a, and the second metal layer 156b may be formed to completely fill the fourth gap G4 defined by the second main layer 152b. The first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the first main layer 152a, the second main layer 152b, the first metal layer 156a, and the second metal layer 156b. Specifically, the first isolation insulating layer 164 and the second isolation insulating layer 166 may be formed, and a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed. In the present embodiment, the first main layer 152a and the first metal layer 156a may be collectively referred to as the direct contact 150, and thus, the bit line 160 may be formed on the direct contact 150. The third isolation insulating layer 168 may be formed to surround the top surface of the bit line 160 and the top surface of the second isolation insulating layer 166. A portion of each of the first, second, and third isolation insulating layers 164, 166, and 168 may be removed so that the top surfaces of the second main layer 152b and the second metal layer 156b are exposed, and the conductive pattern 158 may be formed to fill a space from which the portions of the first, second, and third isolation insulating layers 164, 166, and 168 have been removed. In the present embodiment, the second main layer 152b, the second metal (conductive) layer 156b, and the conductive pattern 158 may be collectively referred to as the buried contact 170.

In the present embodiment, the direct contact 150 and the buried contact 170 may respectively include doped polysilicon layers (i.e., the first main layer 152a and the second main layer 152b), and accordingly, the gas-phase doping process, which is performed before the buried contact 170 is formed in the embodiments described above, may be omitted.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound. In embodiments, the conductive pattern 158 may include metal, and the first metal layer 156a and the second metal layer 156b may include substantially the same material as each other.

The semiconductor memory device 10g described with reference to FIGS. 19A and 19B may be substantially the same as the semiconductor memory device 10 described with reference to FIGS. 12A to 12C, except that the direct contact 150 does not include a buffer layer and is completely formed by forming the first metal layer 156a in the remaining space since the first main layer 152a does not completely fill each of the first space H1 and the second space H2 (see FIG. 11), and that the buried contact 170 includes the second main layer 152b including polysilicon and the second metal layer 156b surrounded by the second main layer 152b and thus has a similar structure to the direct contact 150 and is formed by a similar process to the direct contact 150. Accordingly, the semiconductor memory device 10g may also increase integration density and simplify processes.

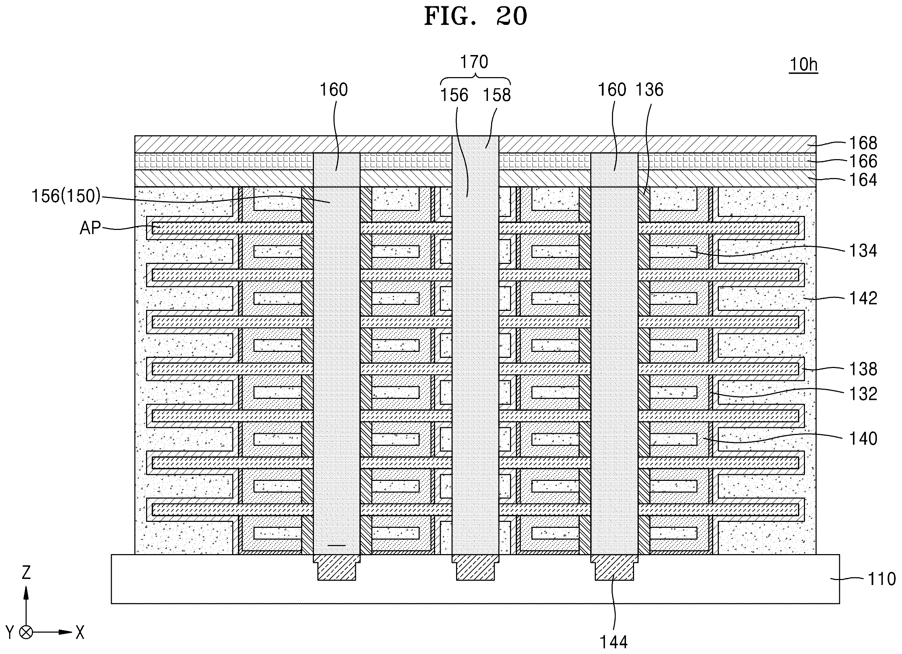

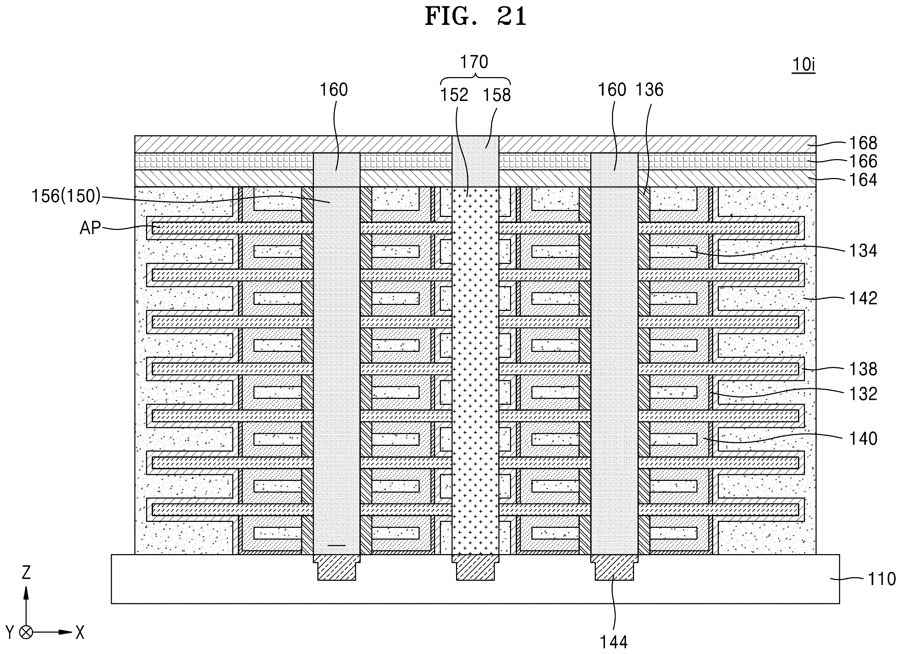

FIGS. 20 and 21 are schematic diagrams of semiconductor memory devices 10h and 10i according to embodiments. The semiconductor memory devices 10h and 10i of FIGS. 20 and 21 and the semiconductor memory device 10 described with reference to FIGS. 3 to 12C are not mutually exclusive, and like elements are denoted by like reference characters. Redundant descriptions of like elements may be omitted below, and the differences between each of the semiconductor memory devices 10h and 10i and the semiconductor memory device 10 of FIGS. 3 to 12C are mainly described.

Referring to FIG. 20, each of the first space H1 and the second space H2 (see FIG. 11) may be completely filled with the metal layer 156. In other words, in the present embodiment, the direct contact 150 may be the metal layer 156. The third space H3 (see FIG. 11) may be completely filled with the metal layer 156.

In embodiments, the first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the metal layer 156, and the direct contact 150. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166. Thereafter, the portion of each of the first, second, and third isolation insulating layers 164, 166, and 168 may be removed so that the top surface of the second metal layer 156b is exposed, and the conductive pattern 158 may be formed in a space, from which the portions of the first, second, and third isolation insulating layers 164, 166, and 168 have been removed, so that the buried contact 170 including the metal layer and the conductive pattern 158 may be obtained.

According to some embodiments, gas-phase doping may be performed as a pre-process before the buried contact 170 is formed. In embodiments, the gas-phase doping may be performed using B, for example, B₂H₆. Before the buried contact 170 is formed, a B₂H₆ gas may be injected in a high-temperature environment so that B may diffuse, as a dopant, from the surfaces of the semiconductor patterns AP. The buried contact 170 may be formed by forming a buried contact junction by using the gas-phase doping process and then filling the third space H3 with a metal material.

In some embodiments, like the buried contact 170, diffusion of a dopant may be induced by using a gas-phase doping process before the direct contact 150 is formed.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound. In embodiments, the conductive pattern 158 may include metal, and the first metal layer 156a and the second metal layer 156b may include substantially the same material as each other.

The semiconductor memory device 10h described with reference to FIG. 20 may be substantially the same as the semiconductor memory device 10 described with reference to FIGS. 12A to 12C, except that both the direct contact 150 and the buried contact 170 are composed of only a metal material. Accordingly, the semiconductor memory device 10h may also increase integration density and simplify processes.

Referring to FIG. 21, each of the first space H1 and the second space H2 (see FIG. 11) may be completely filled with the metal layer 156. In other words, in the present embodiment, the direct contact 150 may be the metal layer 156. The third space H3 (see FIG. 11) may be completely filled with the main layer 152. In embodiments, the main layer 152 may include doped polysilicon. In some embodiments, a dopant included in the main layer 152 may include B.

According to some embodiments, gas-phase doping may be performed as a pre-process before the direct contact 150 is formed. In embodiments, the gas-phase doping may be performed using B, for example, B₂H₆. Before the direct contact 150 is formed, a B₂H₆ gas may be injected in a high-temperature environment so that B may diffuse, as a dopant, from the surfaces of the semiconductor patterns AP. The direct contact 150 may be formed by forming a junction by using the gas-phase doping process and then filling each of the first space H1 and the second space H2 with a metal material.

In embodiments, the first isolation insulating layer 164, the second isolation insulating layer 166, the bit line 160, and the third isolation insulating layer 168 may be sequentially formed to cover the top surfaces of the second gapfill insulating layer 134, the third gapfill insulating layer 142, the word line 140, the first insulating liner 132, the second insulating liner 136, the third insulating liner 138, the main layer 152, and the direct contact 150. Specifically, after the first isolation insulating layer 164 and the second isolation insulating layer 166 are formed, a portion of each of the first isolation insulating layer 164 and the second isolation insulating layer 166 may be removed. The bit line 160 extending in the second horizontal direction (e.g., the Y direction) may be formed in a space, from which the portions of the first isolation insulating layer 164 and the second isolation insulating layer 166 have been removed, to be on the direct contact 150. Thereafter, the third isolation insulating layer 168 may be formed to surround the top surface of the bit line 160 and the top surface of the second isolation insulating layer 166. Thereafter, the portion of each of the first, second, and third isolation insulating layers 164, 166, and 168 may be removed so that the top surface of the main layer 152 is exposed, and the conductive pattern 158 may be formed in a space, from which the portions of the first, second, and third isolation insulating layers 164, 166, and 168 have been removed, so that the buried contact 170 including the main layer 152 and the conductive pattern 158 may be obtained.

In embodiments, the first isolation insulating layer 164 and the third isolation insulating layer 168 may include a nitride-based material, and the second isolation insulating layer 166 may include oxide.

In embodiments, the bit line 160 may include a doped semiconductor material, conductive metal nitride, metal, or a metal-semiconductor compound. In embodiments, the conductive pattern 158 may include metal.

The semiconductor memory device 10i described with reference to FIG. 21 may be substantially the same as the semiconductor memory device 10 described with reference to FIGS. 12A to 12C, except that a portion of the buried contact 170 is composed of the main layer 152 including polysilicon. Accordingly, the semiconductor memory device 10i may also increase integration density and simplify processes.
Embodiments are set out in the following clauses:
Clause 1. A semiconductor memory device comprising: a substrate; a plurality of semiconductor patterns extending in a first horizontal direction on the substrate, the plurality of semiconductor patterns spaced apart from each other in a vertical direction; a first contact connected to the plurality of semiconductor patterns. the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the second contact comprises a metal, and the first contact comprises a main layer comprising doped polysilicon.
Clause 2. The semiconductor memory device of Clause 1, wherein the main layer comprises a dopant comprising boron (B).
Clause 3. The semiconductor memory device of Clause 1 or 2, wherein the second contact comprises a junction that is formed in a gas-phase doping process using boron (B).
Clause 4. The semiconductor memory device of any preceding Clause, wherein the first contact further comprises a buffer layer surrounding the main layer in the first horizontal direction.
Clause 5. The semiconductor memory device of Clause 4, wherein the buffer layer comprises polysilicon that does not include a dopant.
Clause 6. The semiconductor memory device of Clause 4 or Clause 5, wherein a thickness of the buffer layer is less than a thickness of the main layer.
Clause 7. The semiconductor memory device of any preceding Clause, wherein the first contact further comprises a metal layer surrounded by the main layer in the first horizontal direction.
Clause 8. The semiconductor memory device of Clause 7, wherein the first contact further comprises a buffer layer surrounding the main layer in the first horizontal direction.
Clause 9. The semiconductor memory device of Clause 8, wherein the buffer layer comprises polysilicon that does not include a dopant.
Clause 10. The semiconductor memory device of any preceding Clause, further comprising at least one insulating structure below each of the first contact and the second contact.
Clause 11. A semiconductor memory device comprising: a substrate; a plurality of semiconductor patterns extending in a first horizontal direction on the substrate, the plurality of semiconductor patterns spaced apart from each other in a vertical direction; a first contact connected to the plurality of semiconductor patterns, the first contact extending through the plurality of semiconductor patterns in the vertical direction; a bit line on the first contact in the vertical direction, the bit line extending in a second horizontal direction crossing the first horizontal direction; a word line surrounding the plurality of semiconductor patterns, the word line extending in the first horizontal direction; and a second contact spaced apart from the first contact in the first horizontal direction, the second contact extending through the plurality of semiconductor patterns in the vertical direction, wherein the first contact comprises a first main layer, the second contact comprises a second main layer, and each of the first main layer and the second main layer comprises doped polysilicon.
Clause 12. The semiconductor memory device of Clause 11, wherein each of the first main layer and the second main layer comprises a dopant that comprises boron (B).
Clause 13. The semiconductor memory device of Clause 11 or 12, wherein the first contact further comprises a buffer layer surrounding the first main layer in the first horizontal direction, and the buffer layer comprises polysilicon that does not include a dopant.
Clause 14. The semiconductor memory device of Clause 11, 12 or 13, wherein the first contact further comprises a first metal layer surrounded by the first main layer in the first horizontal direction.
Clause 15. The semiconductor memory device of Clause 14, wherein the first contact further comprises a buffer layer surrounding the first main layer in the first horizontal direction.

While non-limiting example embodiments of the disclosure have been described above with reference to the accompanying drawings, it will be understood that various changes in form and details may be made therein without departing from the scope of the disclosure.

## Claims

1. A semiconductor memory device (10) comprising:
a substrate (110);
a plurality of semiconductor patterns (AP) extending in a first horizontal direction (X) on the substrate (110), the plurality of semiconductor patterns (AP) spaced apart from each other in a vertical direction (Z);
a first contact (DC; 150) connected to the plurality of semiconductor patterns (AP), the first contact (DC; 150) extending through the plurality of semiconductor patterns (AP) in the vertical direction (Z);
a bit line (BL; 160) on the first contact (DC; 150) in the vertical direction (Z), the bit line (BL; 160) extending in a second horizontal direction (Y) crossing the first horizontal direction (X);
a word line (WL; 140) surrounding the plurality of semiconductor patterns (AP), the word line (WL; 140) extending in the first horizontal direction (X); and
a second contact (BC; 170) spaced apart from the first contact (DC; 150) in the first horizontal direction (X), the second contact (BC; 170) extending through the plurality of semiconductor patterns (AP) in the vertical direction,
wherein the second contact (BC; 170) comprises a metal, and the first contact (DC; 150) comprises a main layer (152) comprising doped polysilicon.

2. The semiconductor memory device of claim 1, wherein the main layer (152) comprises a dopant comprising boron (B).

3. The semiconductor memory device of claim 1 or 2, wherein the second contact (BC; 170) comprises a junction that is formed in a gas-phase doping process using boron (B).

4. The semiconductor memory device of any preceding claim, wherein the first contact (DC: 150) further comprises a buffer layer (154) surrounding the main layer (152) in the first horizontal direction (X).

5. The semiconductor memory device of claim 4, wherein the buffer layer (154) comprises polysilicon that does not include a dopant.

6. The semiconductor memory device of claim 4 or claim 5, wherein a thickness of the buffer layer (154) is less than a thickness of the main layer (152).

7. The semiconductor memory device of any preceding claim, wherein the first contact (DC; 150) further comprises a metal layer (156) surrounded by the main layer (152) in the first horizontal direction (X).

8. The semiconductor memory device of claim 7, wherein the first contact (DC; 150) further comprises a buffer layer (154) surrounding the main layer (152) in the first horizontal direction (X).

9. The semiconductor memory device of claim 8, wherein the buffer layer (154) comprises polysilicon that does not include a dopant.

10. The semiconductor memory device of any preceding claim, further comprising at least one insulating structure (144) below each of the first contact (DC; 150) and the second contact (BC; 170).

11. The semiconductor memory device of claim 1, wherein the first contact (DC; 150) comprises a first main layer (152a), the second contact (BC; 170) comprises a second main layer (152b), and each of the first main layer (152a) and the second main layer (152b) comprises doped polysilicon.

12. The semiconductor memory device of claim 11, wherein each of the first main layer (152a) and the second main layer (152b) comprises a dopant that comprises boron (B).

13. The semiconductor memory device of claim 11 or claim 12, wherein the first contact (DC; 150) further comprises a buffer layer (154) surrounding the first main layer (152a) in the first horizontal direction (X), and the buffer layer (154) comprises polysilicon that does not include a dopant.

14. The semiconductor memory device of any one of claims 11 to 13, wherein the first contact (DC; 150) further comprises a first metal layer (156a) surrounded by the first main layer (152a) in the first horizontal direction (X).

15. The semiconductor memory device of claim 14, wherein the first contact (DC; 150) further comprises a buffer layer (154) surrounding the first main layer (152a) in the first horizontal direction (X).
